# EUROPEAN PATENT SPECIFICATION

(11) **EP 4 456 135 B1**
(45) Date of publication and mention of the grant of the patent: **06.05.2026**
(21) Application number: 24165216.3
(22) Date of filing: 21.03.2024
(51) Int. Cl.: H10H 29/34, H10H 29/80

(54) **DISPLAY DEVICE**
ANZEIGEVORRICHTUNG
DISPOSITIF D'AFFICHAGE

(30) Priority: 25.04.2023 KR 20230053967
(43) Date of publication of application: 30.10.2024
(73) Proprietor: Samsung Display Co., Ltd., Yongin-si, Gyeonggi-do 17113 (KR)
(72) Inventor: KIM, Su Jeong, 17113 Yongin-si (KR); MIN, Dae Hong, 17113 Yongin-si (KR)
(74) Representative: Walaski, Jan Filip

(56) References cited:
- US-A1- 2023 046 443
- US-A1- 2023 048 385
- US-A1- 2023 065 016

## Description

### BACKGROUND

### 1. Field

The present invention relates to a light-emitting element structure and a display device.

### 2. Description of the Related Art

As the information society develops, the demand for a display device for displaying an image is increasing in various forms. The display device may be a flat panel display, such as a liquid crystal display, a field emission display, or a light-emitting display panel. The light-emitting display device may include an organic light-emitting diode device including an organic light-emitting diode element as a light-emitting element, an inorganic light-emitting device including an inorganic semiconductor element as a light-emitting element, or an ultra-small light-emitting diode element (or a micro light-emitting diode element) as a light-emitting element.

Recently, a head mounted display including a light-emitting display device has been developed. The head mounted display (HMD) is a spectacle-type monitor device of virtual reality (VR) or augmented reality (AR) that the user wears in the form of glasses or a helmet, the focus of which being formed at a close distance in front of the user's eyes. A high-resolution subminiature light-emitting diode display panel including the micro light-emitting diode element may be applied to the head mounted display.
US 2023/0048385 A1 and US 2023/0046443 A1 each disclose a display device and a method for fabrication thereof.

### SUMMARY

The present invention provides a light-emitting element structure and a display device capable of improving the luminous efficiency of light-emitting elements for emitting red light by adjusting the width of a current-spreading layer according to the luminous efficiency of the light-emitting element.

However, the present invention is not restricted to the one set forth herein. The above and other aspects of the present invention will become more apparent to one of ordinary skill in the art to which the present disclosure pertains by referencing the detailed description of the present invention given below.

According to an aspect of the invention, there is provided a light-emitting structure as set out in claim 1. According to embodiments, a light-emitting element structure includes a growth substrate, light-emitting elements including a first light-emitting element for emitting light of a first wavelength and a second light-emitting element for emitting light of a second wavelength on the growth substrate, and including current-spreading layers including a first current-spreading layer having a first width on the first light-emitting element and a second current-spreading layer having a second width that is less than the first width on the second light-emitting element, and an insulating layer between the light-emitting elements.

The first light-emitting element and the second light-emitting element have the same width.

The first wavelength may correspond to red light, wherein the second wavelength corresponds to green light or blue light.

The light-emitting elements may further include a third light-emitting element for emitting light of a third wavelength, wherein the current-spreading layers further include a third current-spreading layer on the third light-emitting element, wherein the first wavelength corresponds to red light, wherein the second wavelength corresponds to green light, and wherein the third wavelength corresponds to blue light.

The light-emitting element structure may further include a first light-emitting area corresponding to the first current-spreading layer, a second light-emitting area corresponding to the second current-spreading layer, and a third light-emitting area corresponding to the third current-spreading layer, wherein a first emission region of the first light-emitting area is greater than a second emission region of the second light-emitting area and a third emission region of the third light-emitting element.

The second emission region may be greater than or equal to the third emission region.

A planar shape of the first current-spreading layer, the second current-spreading layer, and the third current-spreading layer may be circular or polygonal.

The light-emitting elements may include a first semiconductor layer, a second semiconductor layer, and an active layer between the first semiconductor layer and the second semiconductor layer, wherein the first light-emitting element includes a first active layer, wherein the second light-emitting element includes a second active layer, wherein the third light-emitting element includes a third active layer, wherein the first active layer, the second active layer, and the third active layer contain indium, wherein an indium content of the first active layer is greater than an indium content of the second active layer and an indium content of the third active layer, and wherein the indium content of the second active layer is greater than the indium content of the third active layer.

The light-emitting element structure may further include connection electrodes respectively on the current-spreading layers, wherein the connection electrodes respectively have the same width as the current-spreading layers.

The light-emitting element structure may further include connection electrodes respectively the current-spreading layers, and respectively having widths that are different from widths of the current-spreading layers.

According to embodiments a light-emitting element structure includes a growth substrate, light-emitting elements on the growth substrate and including first semiconductor layers, second semiconductor layers, and active layers between the first semiconductor layers and the second semiconductor layers, the light emitting elements including a first light-emitting element including a first active layer and a first current-spreading layer, and a second light-emitting element including a second active layer and a second current-spreading layer, and an insulating layer between the light-emitting elements, wherein the first active layer and the second active layer include indium, an indium content of the first active layer being greater than an indium content of the second active layer, and wherein a first width of the first current-spreading layer is greater than a second width of the second current-spreading layer.

The light-emitting elements may include a third light-emitting element including a third active layer having an indium content that is less than the indium content of the second active layer, wherein a third width of the third current-spreading layer is equal to or less than the second width.

The first light-emitting element and the second light-emitting element may have the same width.

The first light-emitting element and the second light-emitting element may have different respective widths.

According to embodiments, a display device includes pixel electrodes on a substrate, light-emitting elements on the pixel electrodes, and including a first light-emitting element for emitting light of a first wavelength, and a second light-emitting element for emitting light of a second wavelength, an insulating layer between the light-emitting elements, and current-spreading layers including a first current-spreading layer on the first light-emitting element, and a second current-spreading layer on the second light-emitting element, a first width of the first current-spreading layer being greater than a second width of the second current-spreading layer, the first light-emitting element and the second light-emitting element having the same width.

The light-emitting elements may further include a third light-emitting element for emitting light of a third wavelength, wherein the first wavelength corresponds to red light, wherein the second wavelength corresponds to green light, and wherein the third wavelength corresponds to blue light.

The display device may further include a first light-emitting area corresponding to the first current-spreading layer, a second light-emitting area corresponding to the second current-spreading layer, and a third light-emitting area corresponding to the third current-spreading layer, wherein a first emission region of the first light-emitting area is greater than a second emission region of the second light-emitting area and is greater than a third emission region of the third light-emitting element, and wherein the second emission region is greater than or equal to the third emission region.

The light-emitting elements may include first semiconductor layers, second semiconductor layers, and active layers respectively between the first semiconductor layers and the second semiconductor layers, wherein the first light-emitting element includes a first active layer containing indium, wherein the second light-emitting element includes a second active layer containing indium, wherein the third light-emitting element includes a third active layer containing indium, wherein an indium content of the first active layer is greater than an indium content of the second active layer and is greater than an indium content of the third active layer, and wherein the indium content of the second active layer is greater than the indium content of the third active layer.

The display device may further include connection electrodes respectively between the current-spreading layers and the pixel electrodes.

According to embodiments, the luminance of light-emitting elements of different wavelengths may be similarly adjusted by locating a current-spreading layer on the lower surface of the light-emitting element, and by forming a different width (or area) of the current-spreading layer according to the luminous efficiency of the light-emitting element.

In addition, according to embodiments, when the wavelength emitted by the light-emitting element becomes longer, the side wall effect may be reduced or minimized by forming a larger width of the current-spreading layer.

However, the present invention is not limited to the aforementioned effects, and various other aspects are included in the present specification.

### BRIEF DESCRIPTION OF THE DRAWINGS

FIG. 1 is a perspective view illustrating a display device.
FIG. 2 is a layout diagram illustrating area A of FIG. 1 in detail.
FIG. 3 is a layout diagram illustrating a plurality of pixels.
FIG. 4 is a cross-sectional view illustrating an example of a display panel taken along the line A-A' of FIG. 3.
FIG. 5 is an equivalent circuit diagram of one pixel of a display device.
FIG. 6 is an equivalent circuit diagram of one pixel of a display device in another implementation.
FIG. 7 is an equivalent circuit diagram of one pixel of a display device in another implementation.
FIG. 8 is a cross-sectional view illustrating an example of a light-emitting element structure of a display panel.
FIG. 9 is a graph illustrating luminous efficiency according to wavelength.
FIGS. 10 and 11 are layout diagrams illustrating a plurality of pixels.
FIG. 12 is a flowchart illustrating a manufacturing method of a display device.
FIG. 13 is a flowchart illustrating an example of a manufacturing method of S120 of FIG. 12.
FIGS. 14 to 27 are cross-sectional views illustrating a manufacturing method of a display device.
FIG. 28 is a layout diagram illustrating a plurality of pixels in another implementation.
FIG. 29 is a cross-sectional view illustrating an example of a display panel taken along the line A-A' of FIG. 28.
FIG. 30 is a cross-sectional view illustrating an example of a light-emitting element structure of a display panel in another implementation.
FIG. 31 shows a virtual reality device including a display device.
FIG. 32 shows a smart device including a display device.
FIG. 33 shows a vehicle including a display device.
FIG. 34. shows a transparent display device including a display device.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The present disclosure covers all modifications, equivalents, and replacements within the idea and technical scope of the present disclosure. Further, each of the features of the various embodiments of the present disclosure may be combined with each other, in part or in whole, and technically various interlocking and driving are possible. Each embodiment may be implemented independently of each other or may be implemented together in an association.

In the drawings, the relative sizes of elements, layers, and regions may be exaggerated for clarity and/or descriptive purposes. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. In other instances, well-known structures and devices are shown in block diagram form to avoid unnecessarily obscuring various embodiments.

Spatially relative terms, such as "beneath," "below," "lower," "lower side," "under," "above," "upper," "upper side," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or intervening layers, regions, or components may be present. However, "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components such as "between," "immediately between" or "adjacent to" and "directly adjacent to" may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expression such as "at least one of A and B" and "at least one of A or B" may include A, B, or A and B. As used herein, "or" generally means "and/or," and the term "and/or" includes any and all combinations of one or more of the associated listed items. For example, the expression such as "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the spirit and scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

Hereinafter, embodiments will be described with reference to the attached drawings.

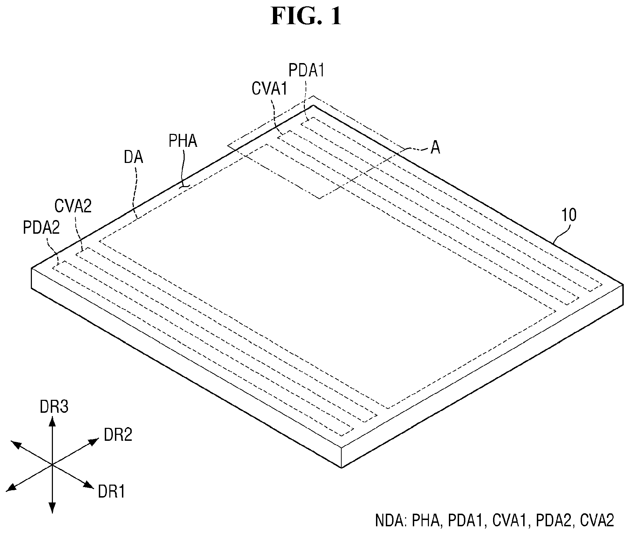

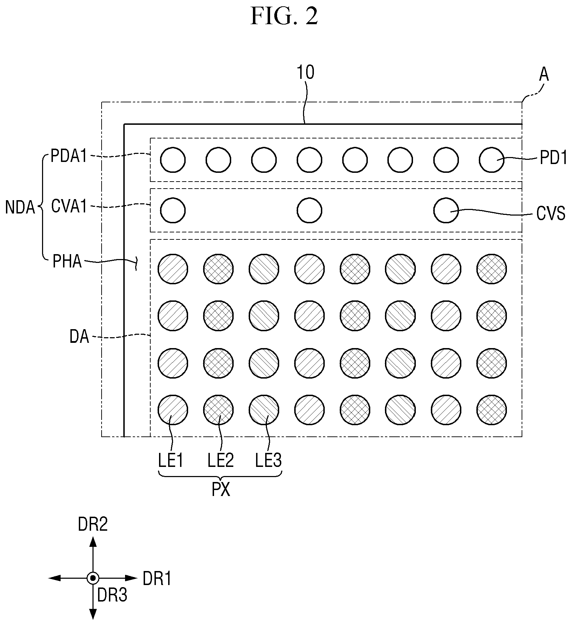

FIG. 1 is a perspective view illustrating a display device. FIG. 2 is a layout diagram illustrating area A of FIG. 1 in detail.

In FIGS. 1 to 2, although it has been mainly described that the display device is a micro light-emitting diode display device including a micro light-emitting diode as a light-emitting element, the present disclosure is not limited thereto.

In addition, in FIGS. 1 to 2, although the display device has been mainly described as a LEDoS (Light Emitting Diode on Silicon) in which light-emitting diode elements are located on a semiconductor circuit board formed using a semiconductor process, it should be noted that implementations are not limited thereto.

In addition, in FIGS. 1 to 2, a first direction DR1 indicates a horizontal direction of a display panel 10, a second direction DR2 indicates a vertical direction of the display panel 10, and a third direction DR3 indicates a thickness direction of the display panel 10. In this case, "left," "right," "top," and "bottom" indicate directions when the display panel 10 is viewed from a plane. For example, "right" refers to one side of the first direction DR1, "left" refers to the other side of the first direction DR1, "upper side" refers to one side of the second direction DR2, and "lower side" refers to the other side in the second direction DR2. Also, "upper" refers to one side in the third direction DR3 and "lower" refers to the other side in the third direction DR3.

Referring to FIGS. 1 to 2, a display device 1 includes the display panel 10 including a display area DA and a non-display area NDA.

The display panel 10 may have a rectangular planar shape having a long side in the first direction DR1, and a short side in the second direction DR2. However, the planar shape of the display panel 10 is not limited thereto, and may have a polygonal, circular, oval, or irregular planar shape other than a quadrangle.

The display area DA is an area in which an image is displayed, and the non-display area NDA is an area in which an image is not displayed. The planar shape of the display area DA may follow the planar shape of the display panel 10. FIG. 1 illustrates that the display area DA has a rectangular shape. The display area DA may be located in a central area of the display panel 10. The non-display area NDA may be located around the display area DA (e.g., in plan view). The non-display area NDA may be located to surround the display area DA (e.g., in plan view).

The display area DA of the display panel 10 includes a plurality of pixels PX. The pixel PX may be defined as a minimum light-emitting unit capable of displaying white light.

Each of the plurality of pixels PX may include the first to third light-emitting elements LE1, LE2, and LE3 for emitting light. In the present disclosure, each of the plurality of pixels PX includes three light-emitting elements LE1, LE2, and LE3 but the present disclosure is not limited thereto. In addition, although each of the first to third light-emitting elements LE1, LE2, and LE3 has been exemplified to have a circular planar shape, they are not limited thereto.

A first light-emitting element LE1 may emit a first light. The first light may be light of a red wavelength band. For example, the main peak wavelength (R-peak) of the first light may be located at about 600 nm to about 700 nm, but is not limited thereto.

A second light-emitting element LE2 may emit a second light. The second light may be light of a green wavelength band. For example, the main peak wavelength (G-peak) of the second light may be located at about 480 nm to about 560 nm, but is not limited thereto.

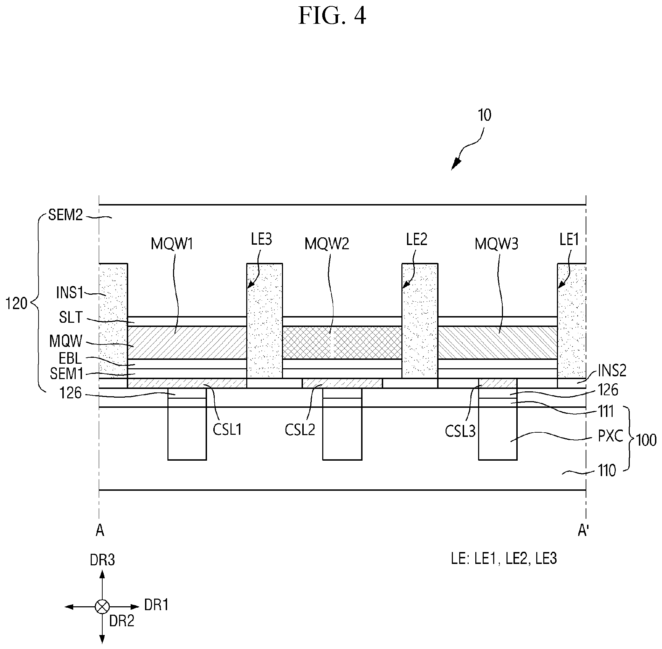

A third light-emitting element LE3 may emit a third light. The third light may be light of a blue wavelength band. For example, the main peak wavelength (B-peak) of the third light may be located at about 370 nm to about 460 nm as shown in (a) of FIG. 4, but is not limited thereto.

The first light-emitting elements LE1, the second light-emitting elements LE2, and the third light-emitting elements LE3 may be alternately arranged in the first direction DR1. For example, the first light-emitting elements LE1, the second light-emitting elements LE2, and the third light-emitting elements LE3 may be arranged in the order of the first light-emitting element LE1, the second light-emitting element LE2, and the third light-emitting element LE3 in the first direction DR1.

The non-display area NDA may include a first common voltage supply area CVA1, a second common voltage supply area CVA2, a first pad area PDA1, a second pad area PDA2, and a peripheral area PHA.

The first common voltage supply area CVA1 may be located between the first pad area PDA1 and the display area DA. The second common voltage supply area CVA2 may be located between the second pad area PDA2 and the display area DA. Each of the first common voltage supply area CVA1 and the second common voltage supply area CVA2 may include a plurality of common voltage supply units CVS connected to a common electrode. The common voltage may be supplied to each of the light-emitting elements LE1, LE2, and LE3 through the plurality of common voltage supply units CVS.

The plurality of common voltage supply units CVS of the first common voltage supply area CVA1 may be electrically connected to one of the first pads PD1 of the first pad area PDA1. That is, the plurality of common voltage supply units CVS of the first common voltage supply area CVA1 may receive the common voltage from one of the first pads of the first pad area PDA1.

The plurality of common voltage supply units CVS of the second common voltage supply area CVA2 may be electrically connected to one of the second pads PD2 of the second pad area PDA2. That is, the plurality of common voltage supply units CVS of the second common voltage supply area CVA2 may receive the common voltage from one of the second pads of the second pad area PDA2.

The first pad area PDA1 may be located above (e.g., at an upper portion of) the display panel 10. The first pad area PDA1 may include the first pads PD1 connected to an external circuit board.

The second pad area PDA2 may be located below (e.g., at a lower portion of) the display panel 10. The second pad aera PDA2 may include the second pads PD2 to be connected to the external circuit board. The second pad area PDA2 may be omitted.

The peripheral area PHA may be an area excluding the first common voltage supply area CVA1, the second common voltage supply area CVA2, the first pad area PDA1, and the second pad area PDA2 in the non-display area NDA. The peripheral area PHA may be located to surround (e.g., in plan view) not only the display area DA, but also the first common voltage supply area CVA1, the second common voltage supply area CVA2, the first pad area PDA1, and the second pad area PDA2.

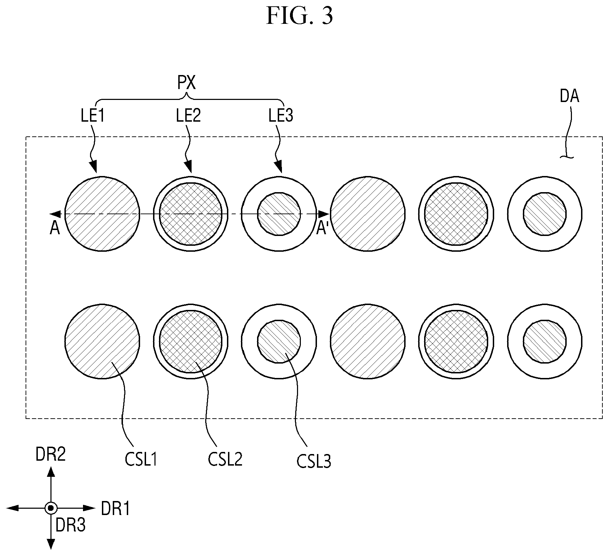

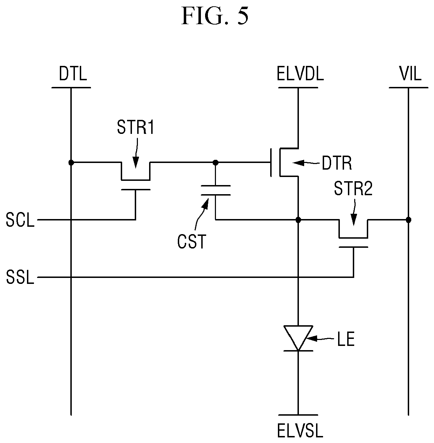

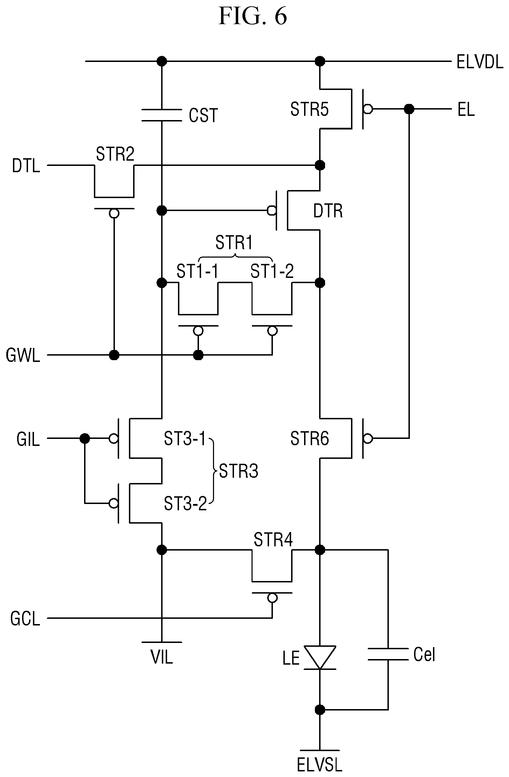

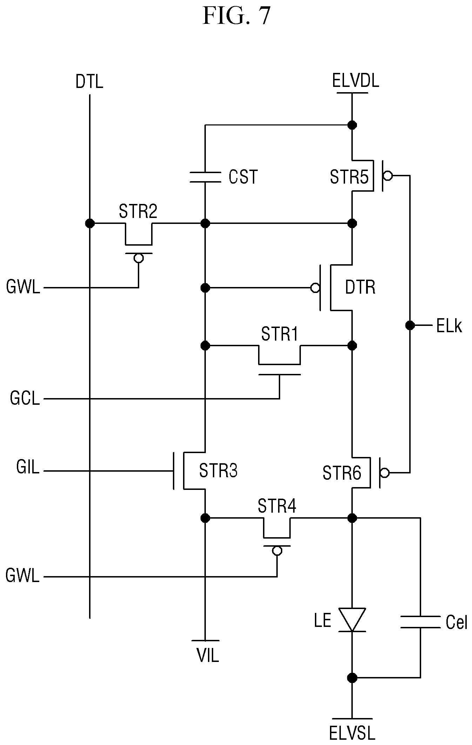

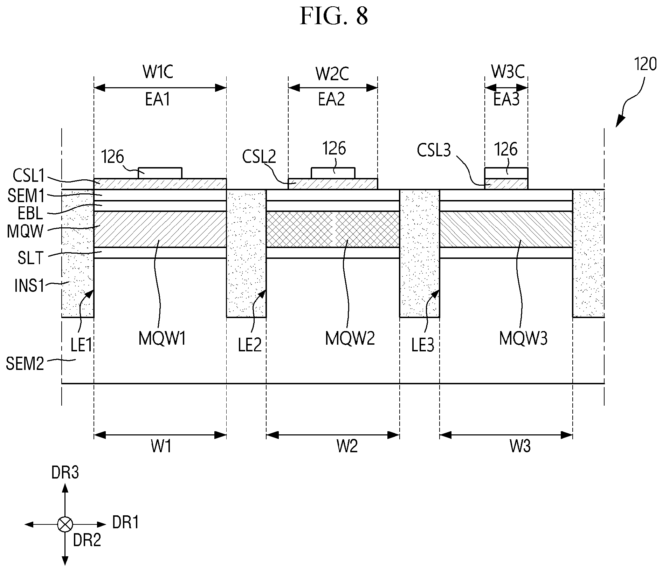

FIG. 3 is a layout diagram illustrating a plurality of pixels. FIG. 4 is a cross-sectional view illustrating an example of a display panel taken along the line A-A' of FIG. 3. FIG. 5 is an equivalent circuit diagram of one pixel of a display device. FIG. 6 is an equivalent circuit diagram of one pixel of a display device in another implementation. FIG. 7 is an equivalent circuit diagram of one pixel of a display device in another implementation. FIG. 8 is a cross-sectional view illustrating an example of a light-emitting element structure of a display panel.

Referring to FIGS. 3 to 8, the display panel 10 may include a semiconductor circuit board 100 and a light-emitting element layer 120.

The semiconductor circuit board 100 may include a first substrate 110, a plurality of pixel circuit units PXC, pixel electrodes 111, and connection electrodes 126.

The first substrate 110 is a silicon wafer substrate formed using the semiconductor process. The plurality of pixel circuit units PXC of the semiconductor circuit board 100 may be formed using the semiconductor process.

The plurality of pixel circuit units PXC may be located in the display area DA. Each of the plurality of pixel circuit units PXC may be connected to the corresponding pixel electrode 111. That is, the plurality of pixel circuit units PXC and a plurality of pixel electrodes 111 may be connected in a one-to-one correspondence. Each of the plurality of pixel circuit units PXC may overlap the light-emitting elements LE1, LE2, and LE3 in the third direction DR3.

Each of the plurality of pixel circuit units PXC may include at least one transistor formed by the semiconductor process. In addition, each of the plurality of pixel circuit units PXC may further include at least one capacitor formed by the semiconductor process. The plurality of pixel circuit units PXC may include, for example, a CMOS circuit. Each of the plurality of pixel circuit units PXC may apply a pixel voltage or an anode voltage to the pixel electrode 111.

Referring to FIG. 5, the plurality of pixel circuit units PXC may include three transistors DTR, STR1, and STR2 and one storage capacitor CST.

The light-emitting element LE emits light according to a current supplied through a driving transistor DTR. The light-emitting element LE may be implemented as an inorganic light-emitting diode, an organic light-emitting diode, a micro light-emitting diode, or a nano light-emitting diode.

The first electrode (e.g., an anode electrode) of the light-emitting element LE may be connected to a source electrode of the driving transistor DTR and the second electrode (e.g., a cathode electrode) may be connected to a second power supply line ELVSL to which a low potential voltage (second power supply voltage), which is lower than a high potential voltage (first power supply voltage) of the first power supply line ELVDL, is supplied.

The driving transistor DTR adjusts a current flowing from the first power supply line ELVDL to which the first power supply voltage is supplied to the light-emitting element LE according to a voltage difference between a gate electrode and a source electrode. The gate electrode of the driving transistor DTR may be connected to the first electrode of the first transistor ST1, the source electrode may be connected to the first electrode of the light-emitting element LE, and the drain electrode may be connected to the first power supply line ELVDL to which the first power supply voltage is applied.

A first transistor STR1 is turned-on by a scan signal of a scan line SCL to connect a data line DTL to the gate electrode of the driving transistor DTR. The gate electrode of the first transistor STR1 may be connected to a scan line SL, the first electrode of the first transistor STR1 may be connected to the gate electrode of the driving transistor DTR, and the second electrode of the first transistor STR1 may be connected to the data line DTL.

A second transistor STR2 is turned-on by a sensing signal of a sensing signal line SSL to connect an initialization voltage line VIL to the source electrode of the driving transistor DTR. The gate electrode of the second transistor ST2 may be connected to the sensing signal line SSL, the first electrode of the second transistor ST2 may be connected to the initialization voltage line VIL, and the second electrode of the second transistor ST2 may be connected to the source electrode of the driving transistor DTR.

The first electrode of each of the first and second transistors STR1 and STR2 may be the source electrode and the second electrode may be the drain electrode and vice versa, but the present disclosure is not limited thereto.

The capacitor CST is formed between the gate electrode and the source electrode of the driving transistor DTR. The storage capacitor CST stores a difference voltage between the gate voltage and the source voltage of the driving transistor DTR.

The driving transistor DTR and the first and second transistors STR1 and STR2 may be formed of the thin film transistors. Also, although the driving transistor DTR and the first and second switching transistors STR1 and STR2 have been mainly described in FIG. 5 as N-type metal oxide semiconductor field effect transistors (MOSFET), the present disclosure is not limited thereto. That is, the driving transistor DTR and the first and second switching transistors STR1 and STR2 may be a P-type MOSFET, some may be a N-type MOSFET, and some may be the P-type MOSFET.

Referring to FIG. 6, the first electrode of the light-emitting element LE of a pixel circuit unit PXC may be connected to the first electrode of a fourth transistor STR4, and to the second electrode of a sixth transistor STR6, and the second electrode of the light-emitting element LE may be connected to the second power supply line ELVSL. A parasitic capacitance Cel may be formed between the first electrode and the second electrode of the light-emitting element LE.

Each pixel PX includes the driving transistor DTR, switch elements, and the capacitor CST. The switch elements include the first to sixth transistors STR1, STR2, STR3, STR4, STR5, and STR6.

The driving transistor DTR includes the gate electrode, the first electrode, and the second electrode. The driving transistor DTR controls a drain-source current (hereinafter referred to as a "driving current") flowing between the first electrode and the second electrode according to the data voltage applied to the gate electrode.

The capacitor CST is formed between the second electrode of the driving transistor DTR and the second power supply line ELVSL. One electrode of the capacitor CST may be connected to the second electrode of the driving transistor DTR, and the other electrode may be connected to the second power supply line ELVSL.

When the first electrode of each of the first to sixth transistors STR1, STR2, STR3, STR4, STR5, STR6 and the driving transistor DTR is the source electrode, the second electrode may be the drain electrode. Alternatively, when the first electrode of each of the first to sixth transistors STR1, STR2, STR3, STR4, STR5, STR6 and the driving transistor DTR is the drain electrode, the second electrode may be the source electrode.

An active layer of each of the first to sixth transistors STR1, STR2, STR3, STR4, STR5, STR6, and the driving transistor DTR may be formed of any one of polysilicon, amorphous silicon, and/or an oxide semiconductor. When the semiconductor layer of each of the first to sixth transistors STR1, STR2, STR3, STR4, STR5, STR6, and the driving transistor DTR is formed of polysilicon, a process for forming the semiconductor layer may be low temperature poly silicon (LTPS) process.

In addition, in FIG. 6, although the first to sixth transistors STR1, STR2, STR3, STR4, STR5, and STR6, and the driving transistor DTR were mainly described as being formed of the P-type MOSFET (Metal Oxide Semiconductor Field Effect Transistor), the present disclosure is not limited thereto, and may be formed of the N-type MOSFET.

Furthermore, the first power supply voltage of the first power supply line ELVDL, the second power supply voltage of the second power supply line ELVSL, and the third power supply voltage of the third power supply line VIL may be set in consideration of characteristics of the driving transistor DTR, characteristics of the light-emitting element LE, and the like.

The implementation corresponding to FIG. 7 is different from the implementation corresponding to FIG. 6, in that the driving transistor DTR, the second transistor STR2, the fourth transistor STR4, the fifth transistor STR5, and the sixth transistor STR6 are formed of the P-type MOSFET and the first transistor STR1 and the third transistor STR3 are formed of the N-type MOSFET in the pixel circuit unit PXC.

Each active layer of the driving transistor DTR, the second transistor STR2, the fourth transistor STR4, the fifth transistor STR5, and the sixth transistor STR6 formed of the P-type MOSFET may be formed of polysilicon and each active layer of the first transistor STR1 and the third transistor STR3 formed of the N-type MOSFET may be formed of the oxide semiconductor.

The implementation corresponding to FIG. 7 is different from the implementation corresponding to FIG. 5 in that the gate electrode of the second transistor STR2 and the gate electrode of the fourth transistor STR4 are connected to a write scan line GWL, and in that the gate electrode of the first transistor ST1 is connected to a control scan line GCL. In addition, in FIG. 7, because the first transistor STR1 and the third transistor STR3 are formed of the N-type MOSFET, a scan signal of a gate high voltage may be applied to the control scan line GCL and to an initialization scan line GIL. In contrast, because the second transistor STR2, the fourth transistor STR4, the fifth transistor STR5, and the sixth transistor STR6 are formed of the P-type MOSFET, a scan signal of a gate low voltage may be applied to the write scan line GWL and a light-emitting line EL.

It should be noted that the above-described equivalent circuit diagram of the pixel is not limited to that illustrated in FIGS. 5 to 7. The equivalent circuit diagram of the pixel may be formed in other known circuit structures employable by those skilled in the art in addition to the structures shown in FIGS. 5 to 7.

Meanwhile, the plurality of pixel electrodes 111 may be located on the corresponding pixel circuit unit PXC. Each of the pixel electrodes 111 may be an exposed electrode exposed from the pixel circuit unit PXC. Each of the pixel electrodes 111 may be integrally formed with the pixel circuit unit PXC. Each of the pixel electrodes 111 may receive the pixel voltage or the anode voltage from the pixel circuit unit PXC. The pixel electrodes 111 may include at least one of gold (Au), copper (Cu), tin (Sn), or silver (Ag). For example, the pixel electrode 111 may include a 9:1 alloy, an 8:2 alloy, or a 7:3 alloy of gold and tin, or an alloy of copper, silver, and/or tin (SAC305).

The light-emitting element layer 120 may include light-emitting elements LE1, LE2, and LE3 and an insulating layer INS1. Because the light-emitting element layer 120 includes a plurality of light-emitting elements LE1, LE2, and LE3, it may be referred to as a light-emitting element structure.

Referring to FIG. 8, the light-emitting element layer 120 may include first light-emitting areas EA1, second light-emitting areas EA2, and third light-emitting areas EA3 respectively corresponding to current-spreading layers CSL1, CSL2, and CSL3 of each light-emitting element LE1, LE2, and LE3. Light emitting elements LE may be located in a one-to-one correspondence with each of the first light-emitting areas EA1, the second light-emitting areas EA2, and the third light-emitting areas EA3.

The light-emitting element LE may be located on the pixel electrode 111 in each of the first light-emitting areas EA1, the second light-emitting areas EA2, and the third light-emitting areas EA3. The light-emitting element LE may be a vertical light-emitting diode element extending lengthwise in the third direction DR3. That is, the length of the light-emitting element LE in the third direction DR3 may be longer than that in the horizontal direction. The length in the horizontal direction refers to the length of the first direction DR1 or the length of the second direction DR2. For example, the length of the third direction DR3 of the light-emitting element LE may be about 1 µm to about 5 µm but is not limited thereto.

The light-emitting element LE may have a cylindrical shape, a disk shape, or a rod shape where the width is longer than the height, but is not limited thereto. The light-emitting element LE has a shape, such as a rod, a wire, or a tube, or a polygonal column shape, such as a regular hexahedron, a rectangular parallelepiped, or a hexagonal prism. Also, the light-emitting element LE may have various shapes, such as a shape extending in one direction and having an outer surface partially inclined.

The light-emitting element LE may be a micro light-emitting diode element. The light-emitting element LE may include a connection electrode 126, a current-spreading layer CSL, a first semiconductor layer SEM1, an electron-blocking layer EBL, an active layer MQW, a superlattice layer SLT, and a second semiconductor layer SEM2. The connection electrode 126, the current-spreading layer CSL, the first semiconductor layer SEM1, the electron-blocking layer EBL, the active layer MQW, the superlattice layer SLT, and the second semiconductor layer SEM2 may be sequentially stacked in the third direction DR3.

The connection electrode 126 may be directly located on the pixel electrode 111. The connection electrode 126 may serve as a bonding metal for mutually bonding the pixel electrode 111 and the light-emitting elements LE in a manufacturing process. The connection electrode 126 may include a material electrically connected to the pixel electrode 111 and the light-emitting elements LE. For example, the connection electrode 126 may include at least one of gold (Au), copper (Cu), aluminum (Al), or tin (Sn), or may include a transparent conductive oxide, such as indium tin oxide (ITO) or indium zinc oxide (IZO). Alternatively, the connection electrode 126 may include a first layer including any one of gold (Au), copper (Cu), aluminum (Al), and/or tin (Sn) and a second layer including another one of gold (Au), copper (Cu), aluminum (Al), and/or tin (Sn). As such, in some cases, the light-emitting element LE may include a larger number of connection electrodes 126 or may be omitted. A description of the light-emitting element LE to be described later may be equally applied even if the number of connection electrodes 126 is changed or another structure is further included.

The connection electrode 126 is illustrated as having the same area as the pixel electrode 111 but is not limited thereto. It may have the same area as the current-spreading layer CSL, which will be described later.

The current-spreading layer CSL may be located between the connection electrode 126 and the first semiconductor layer SEM1. The current-spreading layer CSL may reduce resistance between the light-emitting element LE and the connection electrode 126 when the light-emitting element LE is electrically connected to the pixel electrode 111 in the display panel 10. The current-spreading layer CSL may be formed of a transparent conductive material, such as indium tin oxide (ITO) or indium zinc oxide (IZO).

Because the current-spreading layer CSL directly contacts the first semiconductor layer SEM1, and also reduces the resistance between the first semiconductor layers SEM1, the light-emitting element LE may emit light only in a region directly contacting the current-spreading layer CSL. Accordingly, a region in direct contact between the current-spreading layer CSL and the first semiconductor layer SEM1 may be defined as an emission region. For example, when the first light-emitting element LE1 includes a first current-spreading layer CSL1 having a first width W1C, the second light-emitting element LE2 includes a second current-spreading layer CSL2 having a second width W2C, less than the first width W1C, the third light-emitting element LE3 includes a third current-spreading layer CSL3 having a third width W3C, the first light-emitting element LE1 has a first light-emitting area EA1 equal to the first width W1C, the second light-emitting element LE2 has a second light-emitting area EA2 equal to the second width W2C, the third light-emitting element LE3 has a third light-emitting area EA3 equal to the third width W3C.

The first semiconductor layer SEM1 may be located on the current-spreading layer CSL. The first semiconductor layer SEM1 may be a P-type semiconductor and may include a semiconductor material having a chemical formula of

### AlxGayIn1-x-yN(0≤x≤1, 0≤y≤1, 0≤x+y≤1).

For example, it may be any one or more of P-type doped AlGaInN, GaN, AlGaN, InGaN, AIN, and InN. The first semiconductor layer SEM1 may be doped with a P-type dopant, and the P-type dopant may be Mg, Zn, Ca, Se, or Ba. For example, the first semiconductor layer SEM1 may be p-GaN doped with P-type Mg. The thickness of the first semiconductor layer SEM1 may have a range from about 30 nm to about 200 nm but is not limited thereto.

The electron-blocking layer EBL may be located on the first semiconductor layer SEM1. The electron-blocking layer EBL may be a layer for suppressing, reducing, or preventing too many electrons from flowing into the active layer MQW. For example, the electron-blocking layer EBL may be p-AlGaN doped with P-type Mg. The thickness of the electron-blocking layer EBL may have a range of about 10 nm to about 50 nm but is not limited thereto. Also, the electron-blocking layer EBL may be omitted.

The active layer MQW may include a material having a single or multiple quantum well structure. When the active layer MQW includes a material having a multi-quantum well structure, a plurality of well layers and barrier layers may be alternately stacked. In this case, the well layer may be formed of InGaN, and the barrier layer may be formed of GaN or AlGaN but is not limited thereto. A thickness of the well layer may be about 1 nm to about 4 nm, and the thickness of the barrier layer may be about 3 nm to about 10 nm.

Alternatively, the active layer MQW may have a structure in which a semiconductor material having a large band gap energy and a semiconductor material having a small band gap energy are alternately stacked with each other, and may include other Group 3 to Group 5 semiconductor materials depending on the wavelength band of the emitted light. Light emitted from the active layer MQW may emit the first light (light of a red wavelength band), the second light (light of a green wavelength band), or the third light (light of a green wavelength band).

When indium is included among the semiconductor materials included in the active layer MQW, the color of emitted light may vary according to the amount of indium. For example, when the indium content is about 10% to about 15%, light in a blue wavelength band may be emitted, when the indium content is about 20% to about 25%, light in a green wavelength band may be emitted, and when the content of indium is about 30% to about 45%, light in a red wavelength band may be emitted.

The superlattice layer SLT may be located on the active layer MQW. The superlattice layer SLT may be a layer for relieving stress between the second semiconductor layer SEM2 and the active layer MQW. For example, the superlattice layer SLT may be formed of InGaN or GaN. A thickness of the superlattice layer SLT may be about 50 to about 200 nm. The superlattice layer SLT may be omitted.

The second semiconductor layer SEM2 may be located on the superlattice layer SLT. The second semiconductor layer SEM2 may be an N-type semiconductor. The second semiconductor layer SEM2 may include a semiconductor material having a chemical formula of AlxGayIn1-x-yN(0≤x≤1, 0≤y≤1, 0≤x+y≤1). For example, it may be any one or more of N-type doped AlGaInN, GaN, AlGaN, InGaN, AIN, and InN. The second semiconductor layer SEM2 may be doped with an N-type dopant, and the N-type dopant may be Si, Ge, or Sn. For example, the second semiconductor layer SEM2 may be n-GaN doped with N-type Si. The thickness of the second semiconductor layer SEM2 may have a range from about 2 µm to about 4 µm but is not limited thereto.

As shown in FIG. 4, the second semiconductor layer SEM2 may be a common layer located to be commonly connected to a plurality of light-emitting elements LE. A portion of the second semiconductor layer SEM2 continuously extends in the first direction DR1 and may be commonly located in the plurality of light-emitting elements LE, but is not limited thereto.

At least a portion of each light-emitting element LE may be located in the third direction DR3 to form a patterned shape. In another modification, the entirety of the second semiconductor layer SEM2 may be formed in a patterned shape by being located on each light-emitting element LE. When the entire second semiconductor layer SEM2 is formed in a patterned shape, the common electrode that is commonly connected to, and located on, the plurality of light-emitting elements LE may be further located on the second semiconductor layer SEM2.

When a portion of the second semiconductor layer SEM2 continuously extends in the first direction DR1 and is commonly located in the plurality of light-emitting elements LE, the second semiconductor layer SEM2 allows the common voltage applied from the common voltage supply unit (CVS of FIG. 2) to be commonly applied to the plurality of light-emitting elements LE. The second semiconductor layer SEM2 may be located to extend from the display area DA to the non-display area NDA.

The above-described light-emitting elements LE receive the pixel voltage or anode voltage of the pixel electrode 111 through the connection electrode 126, and the common voltage may be supplied through the second semiconductor layer SEM2. The light-emitting element LE may emit light with a luminance (e.g., a predetermined luminance) according to a voltage difference between the pixel voltage and the common voltage.

The insulating layer INS1 may partition each light-emitting element LE and each light-emitting area EA1, EA2, and EA3. The insulating layer INS1 is located to surround the light-emitting elements LE, and may directly contact side surfaces of the light-emitting elements LE. Accordingly, the light-emitting elements LE may not be exposed to external foreign substances, such as dust or air, during the manufacturing process of the display device. In addition, because each of the light-emitting elements LE may be partitioned by the insulating layer INS1, the light-emitting element LE may be individualized without an etching process of the light-emitting element LE.

The insulating layer INS1 may include an inorganic insulating material, such as silicon oxide (SiOx), silicon nitride (SiNx), silicon oxynitride (SiOxNy), aluminum oxide (AlxOy), or aluminum nitride (AIN). A thickness of the insulating layer INS1 may be about 0.1 µm to about 10 µm but is not limited thereto.

In general, in the case of a short wavelength, the luminous efficiency due to the side wall effect tends to decrease. In the light-emitting element structure, the width of the current-spreading layer is increased as the wavelength increases, so that only regions not affected by the side wall effect are used as the light-emitting region. Therefore, the side wall effect of short wavelength may be reduced or minimized.

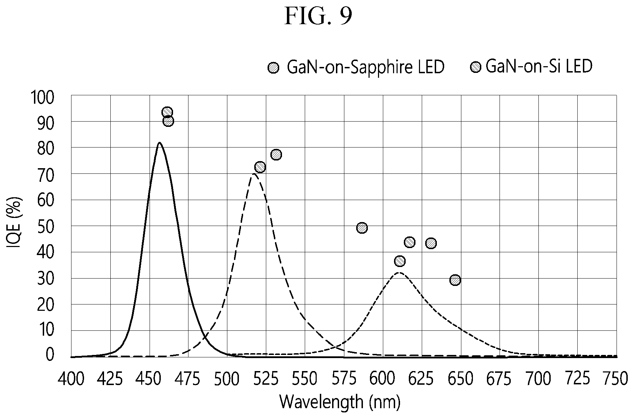

FIG. 9 is a graph illustrating luminous efficiency according to wavelength.

Referring to FIG. 9, the luminous efficiency IQE of the first light having a wavelength of about 600 nm to about 700 nm is the lowest at about 30, the luminous efficiency IQE of the second light having a wavelength of about 480 nm to about 560 nm is about 70, and the luminous efficiency IQE of the third light having a wavelength of about 430 nm to about 460 nm is about 80.

Through this, it was confirmed that the luminous efficiency was different from each other according to the wavelength of light.

Hereinafter, the present disclosure discloses a display device capable of maintaining similar luminous efficiency even at different wavelengths by adjusting the size of the current-spreading layer.

Referring to FIGS. 2 to 4 and 8, a width W1 of the first light-emitting element LE1, a width W2 of the second light-emitting element LE2, and a width W3 of the third light-emitting element LE3 are equal. The widths W1, W2, and W3 of each of the light-emitting elements LE1, LE2, and LE3 may be the distance between one side and the other side in the first direction DR1. When each of the light-emitting elements LE1, LE2, and LE3 has a circular shape, the width may be the diameter of each light-emitting element LE1, LE2, and LE3.

The width W1 of the first light-emitting element LE1 is the same as the width W2 of the second light-emitting element LE2 and may be the same as the width W3 of the third light-emitting element LE3.

Meanwhile, the first width W1C of the first current-spreading layer CSL1 of the first light-emitting element LE1 is greater than the second width W2C of the second current-spreading layer CSL2 of the second light-emitting element LE2 and may be greater than the third width W3C of the third current-spreading layer CSL3 of the third light-emitting element LE3, such that light-emitting efficiency of the first light-emitting element LE1 may increase. The widths W1C, W2C, and W3C of the current-spreading layer CSL of each light-emitting element LE1, LE2, and LE3 may be the distance between one side and the other side in the first direction DR1. When the planar shape of each current-spreading layer CSL is circular, the width may be the diameter of each current-spreading layer CSL.

Accordingly, the luminance of the first light of the first light-emitting element LE1, the luminance of the second light of the second light-emitting element LE2, and the luminance of the third light of the third light-emitting element LE3 may be maintained at about the same level. That is, when the size of each of the light-emitting elements LE1, LE2, and LE3 is small in the range of about several to about several tens of microns, the width of the first current-spreading layer CSL1 of the first light-emitting element LE1 for emitting red light is larger than that of the other light-emitting elements CSL. As a result, application to ultra-high resolution may be possible by improving the luminous efficiency of the first light-emitting element LE1.

When the first width W1C is greater than the third width W3C, the second width W2C may be greater than or equal to the third width W3C. For example, the second width W2C may be greater than the third width W3C. Also, the second width W2C may be the same as the third width W3C.

As shown in FIG. 3, when the first light-emitting element LE1, the second light-emitting element LE2, and the third light-emitting element LE3 have the same size, the area of the first light-emitting area EA1 is greater than the area of the second light-emitting area EA2 and may be greater than the area of the third light-emitting area EA3. Also, the area of the second light-emitting area EA2 may be greater than or equal to the area of the third light-emitting area EA3.

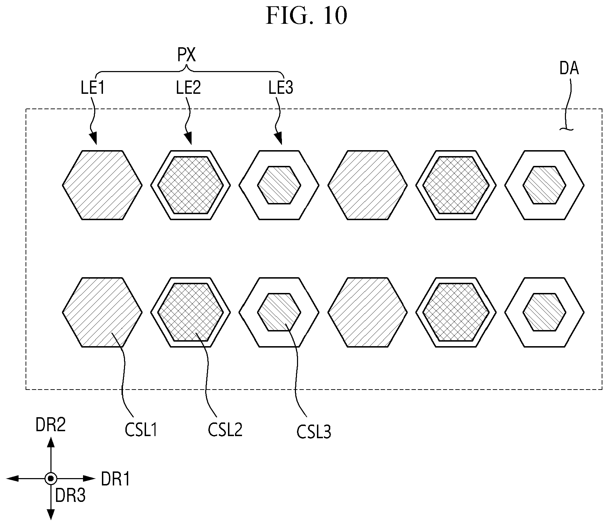

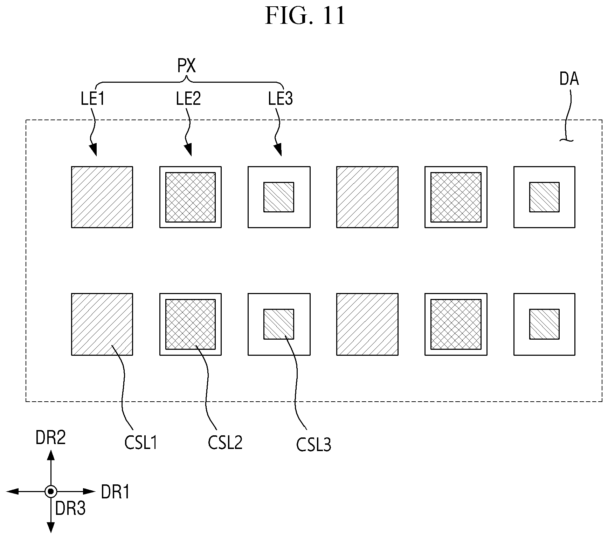

FIGS. 10 and 11 are layout diagrams illustrating a plurality of pixels.

Referring to FIGS. 10 and 11, the above-described light-emitting elements LE1, LE2, and LE3 may be arranged in various shapes.

In the display area DA, the first light-emitting elements LE1 may be located in the first and second directions DR1 and DR2.

The first light-emitting element LE1, the second light-emitting element LE2, and the third light-emitting element LE3 may be alternately located in the first direction DR1.

In each of the plurality of pixels PX, the second light-emitting element LE2 may be located in the first direction DR1 from the first light-emitting element LE1. The third light-emitting element LE3 may be located in the first direction DR1 from the second light-emitting element LE2.

The first light-emitting element LE1, the second light-emitting element LE2, and the third light-emitting element LE3 may be arranged in the second direction DR2.

The areas of the first light-emitting element LE1, the second light-emitting element LE2, and the third light-emitting element LE3 may be the same, and the areas of the current-spreading layers CSL of the light-emitting elements LE may be different from each other. For example, the area of the first current-spreading layer CSL1 may be greater than the area of the second current-spreading layer CSL2, and the area of the second current-spreading layer CSL2 may be greater than that of the third current-spreading layer CSL3. In one or more other implementations, the area of the second current-spreading layer CSL2 may be the same as the area of the third current-spreading layer CSL3.

In addition, although the distance between the first light-emitting element LE1 and the second light-emitting element LE2 adjacent to each other, the distance between the second light-emitting element LE2 and the third light-emitting element LE3 adjacent to each other, and the distance between the first light-emitting element LE1 and the third light-emitting element LE3 adjacent to each other may be substantially the same, the present disclosure is not limited thereto. For example, the distance between the first light-emitting element LE1 and the second light-emitting element LE2 adjacent to each other may be different from the distance between the second light-emitting element LE2 and the third light-emitting element LE3 adjacent to each other. Also, the distance between the first light-emitting element LE1 and the third light-emitting element LE3 adjacent to each other may be different from the distance between the second light-emitting element LE2 and the third light-emitting element LE3 adjacent to each other.

As shown in FIG. 10, the first light-emitting element LE1, the second light-emitting element LE2, and the third light-emitting element LE3 may have a hexagonal planar shape. Also, as shown in FIG. 11, the first light-emitting element LE1, the second light-emitting element LE2, and the third light-emitting element LE3 may have a rectangular planar shape. Also, the first light-emitting element LE1, the second light-emitting element LE2, and the third light-emitting element LE3 may have a triangular planar shape. In other implementations, the planar shape of at least one of the planar shapes of the first light-emitting element LE1, the second light-emitting element LE2, or the third light-emitting element LE3 may be different. For example, the planar shape of the first light-emitting element LE1 may be a rectangle, and the planar shapes of the second light-emitting element LE2 and the third light-emitting element LE3 may be hexagonal. Also, the planar shape of the first light-emitting element LE1 may be circular, the planar shape of the second light-emitting element LE2 may be a rectangle, and the planar shape of the third light-emitting element LE3 may be a triangle.

However, implementations are not limited thereto. For example, the first light-emitting element LE1, the second light-emitting element LE2, and the third light-emitting element LE3 may have a polygonal shape, such as the triangle, the quadrangle, a pentagon, a hexagon, and an octagon, an ellipse, or an irregular shape.

The planar shape of the current-spreading layer CSL may be formed according to the planar shapes of the light-emitting elements LE1, LE2, and LE3. For example, if the planar shapes of the light-emitting elements LE1, LE2, and LE3 are circular, the planar shape of the current-spreading layer CSL is also circular, and if the planar shapes of the light-emitting elements LE1, LE2, and LE3 are polygonal, the current the planar shape of the current-spreading layer CSL may also be polygonal.

As described above, because the light-emitting areas of the light-emitting elements LE1, LE2, and LE3 correspond to the current-spreading layer CSL, respectively, the planar shape of each of the first light-emitting area of the first light-emitting element LE1, the second light-emitting area of the second light-emitting element LE2, and the third light-emitting regions of the third light-emitting element LE3 may be circular or polygonal.

Hereinafter, a manufacturing process of the display device 1 will be described with reference to other drawings.

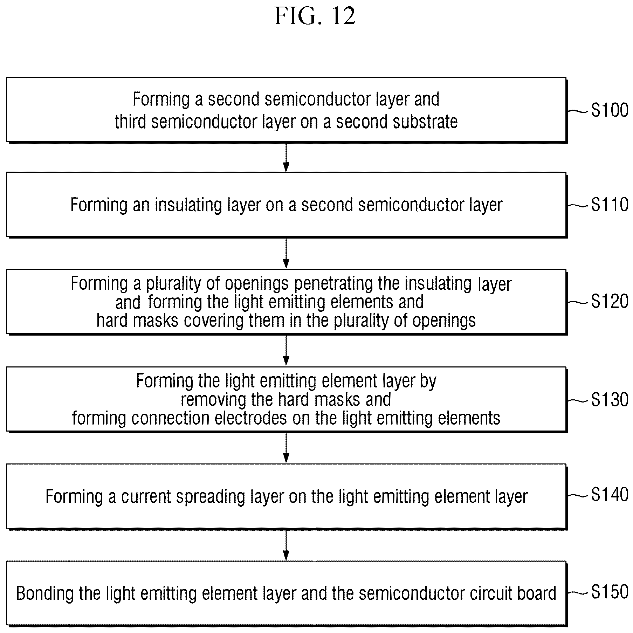

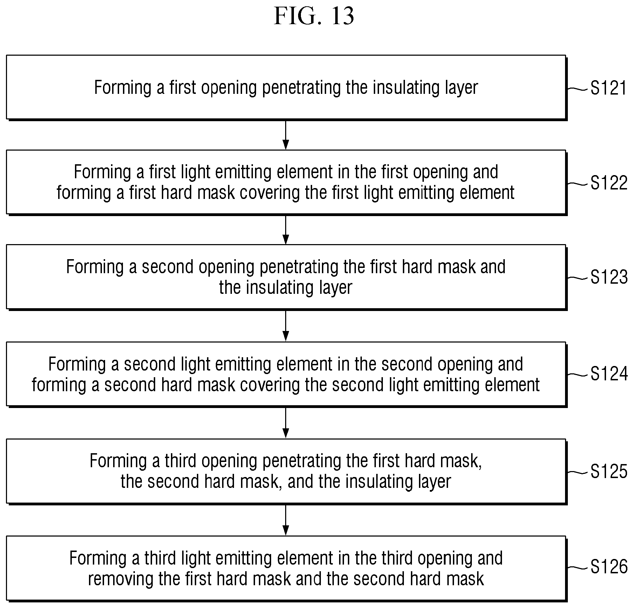

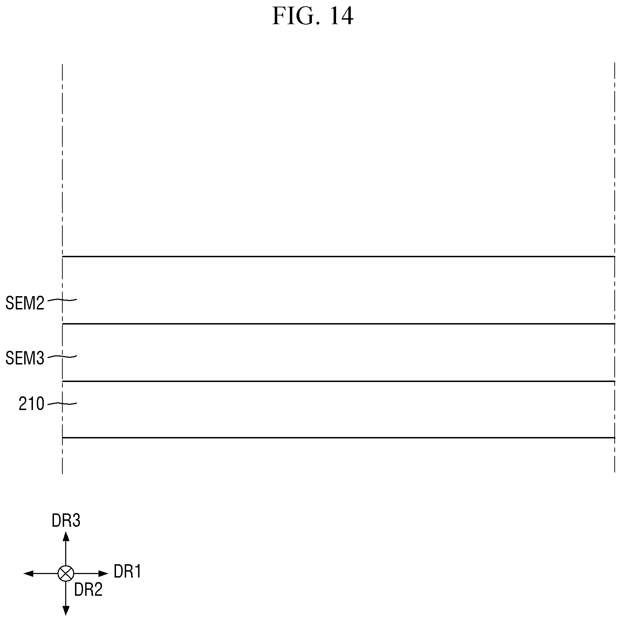

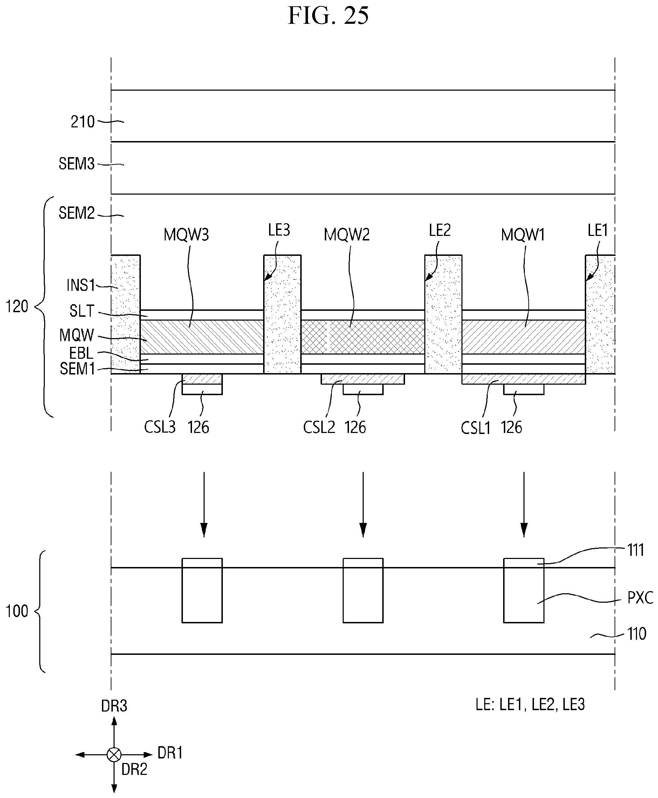

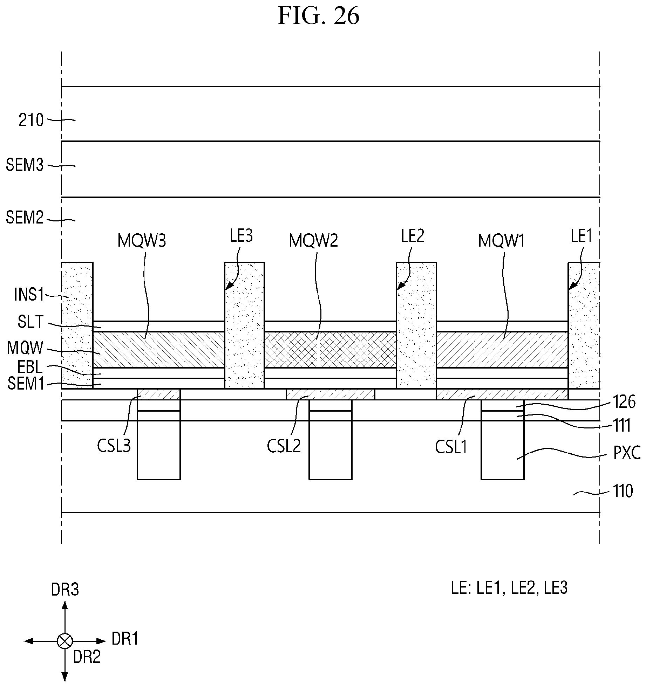

FIG. 12 is a flowchart illustrating a manufacturing method of a display device. FIG. 13 is a flowchart illustrating an example of a manufacturing method of S120 of FIG. 12. FIGS. 14 to 27 are cross-sectional views illustrating a manufacturing method of a display device.

In FIG. 12, operations S100 to S140 illustrate a method of manufacturing a light-emitting device structure.

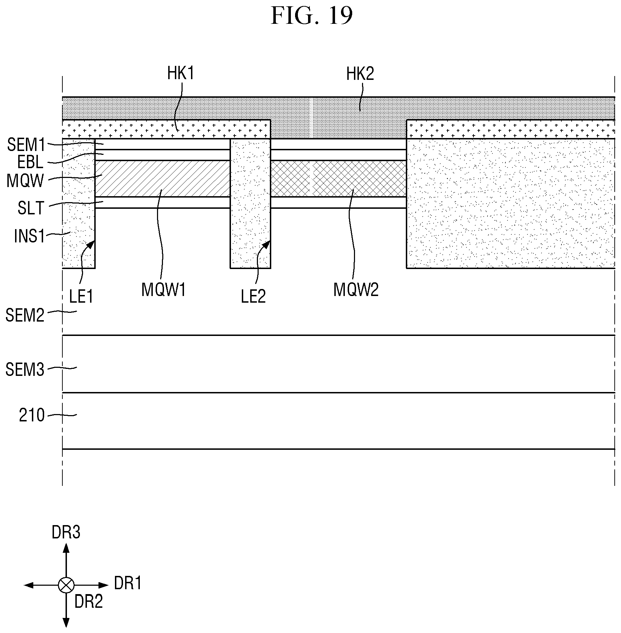

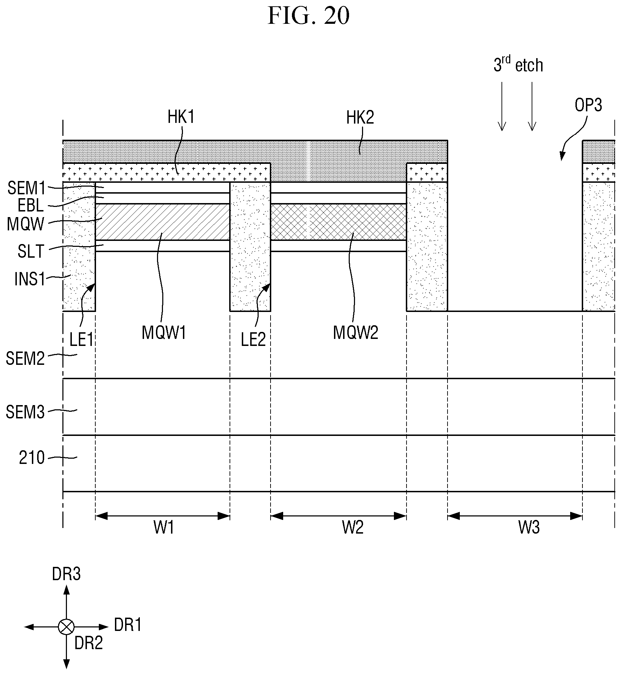

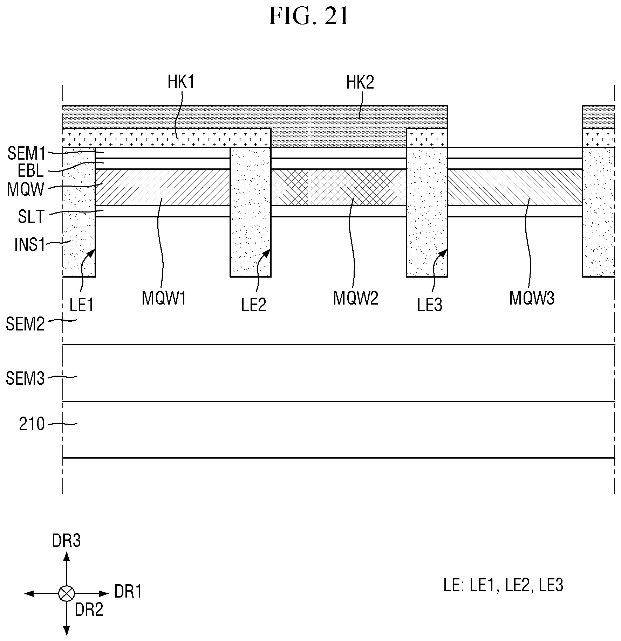

FIGS. 14 to 27 illustrate a structure according to the formation order of each layer of the display panel 10 of the display device 1 as cross-sectional views, respectively. In FIGS. 21 to 27 the manufacturing process of the light-emitting element layer 120 is mainly illustrated, and these may correspond to the cross-sectional view of FIG. 8. Hereinafter, a method of manufacturing the display panel shown in FIGS. 21 to 27 will be described in conjunction with FIGS. 19 and 20.

Referring to FIG. 14, the second semiconductor layer SEM2 and a third semiconductor layer SEM3 are formed on a second substrate 210 (S100 in FIG. 12).

For example, first, the second substrate 210 is prepared. The second substrate 210 may be a sapphire substrate (Al₂O₃) or a silicon wafer containing silicon. However, it is not limited thereto, and a case in which the second substrate 210 is a sapphire substrate will be described as an example.

The second semiconductor layer SEM2 and the third semiconductor layer SEM3 are formed on the second substrate 210. The second semiconductor layer SEM2 and the third semiconductor layer SEM3 may be grown by an epitaxial method or may be formed by growing a seed crystal. Here, the method of forming the semiconductor layer is electron beam deposition, physical vapor deposition (PVD), chemical vapor deposition (CVD), plasma laser deposition (PLD), dual-type thermal evaporation, sputtering, metal organic chemical vapor deposition (MOCVD), and the like, preferably, it may be formed by metal-organic chemical vapor deposition (MOCVD). However, it is not limited thereto.

A precursor material for forming the second semiconductor layer SEM2 and the third semiconductor layer SEM3 is not particularly limited within a range that may be selected normally to form the target substance. For example, the precursor material may be a metal precursor including an alkyl group, such as a methyl group or an ethyl group. For example, it may be a compound, such as trimethyl gallium (Ga(CH₃)₃), trimethyl aluminum (Al(CH₃)₃), and triethyl phosphate ((C₂H₅)₃PO₄), but is not limited thereto.

For example, the third semiconductor layer SEM3 is formed on the second substrate 210. Although the figure illustrates that the third semiconductor layer SEM3 is stacked in one layer, it is not limited thereto, and a plurality of layers may be formed. The third semiconductor layer SEM3 may be located to reduce a lattice constant difference between the second semiconductor layer SEM2 and the second substrate 210. For example, the third semiconductor layer SEM3 may include an undoped semiconductor and may be a material that is not N-type or P-type doped. The third semiconductor layer SEM3 may be at least one of undoped InAlGaN, GaN, AlGaN, InGaN, AIN, or InN, but is not limited thereto.

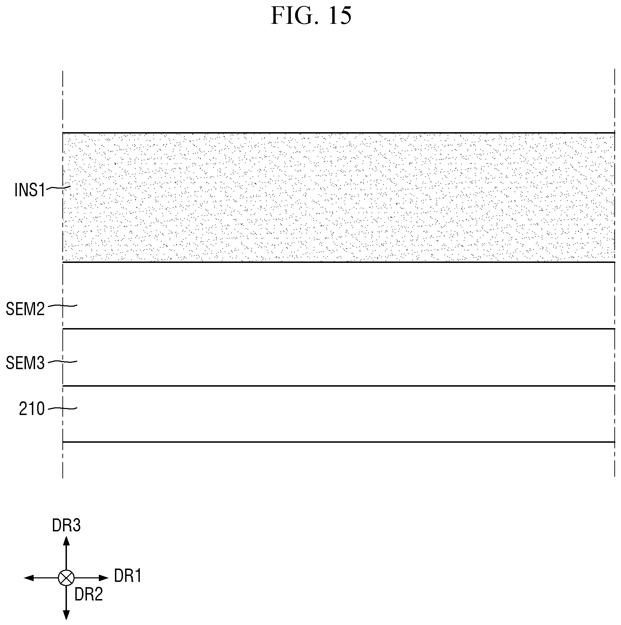

Next, referring to FIG. 15, the insulating layer INS1 is formed on the second semiconductor layer SEM2 (S110 in FIG. 12).

The insulating layer INS1 may be formed entirely on the second semiconductor layer SEM2. The insulating layer INS1 may include the insulating material, such as silicon oxide (SiOx), silicon nitride (SiNx), or silicon oxynitride (SiOxNy), and may function as a mask in a process of forming the light-emitting elements LE.

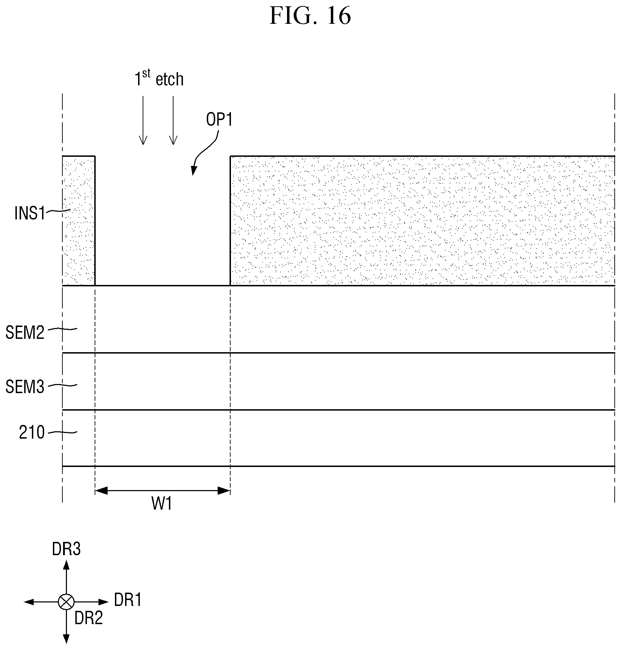

Next, referring to FIGS. 16 to 21, a plurality of openings penetrating the insulating layer INS1 are formed to form light-emitting elements LE and hard masks HK1 and HK2 covering respective ones of the openings in the plurality of openings. (S120 of FIG. 12)

For example, referring to FIG. 16, a plurality of first openings OP1 exposing the second semiconductor layer SEM2 are formed by etching the insulating layer INS1 (S121 of FIG. 13). The plurality of first openings OP1 are formed to be spaced apart from each other. The first light-emitting element LE1 is formed in the plurality of first openings OP1. The width W1 of the first openings OP1 is the same than other openings formed in a subsequent process.

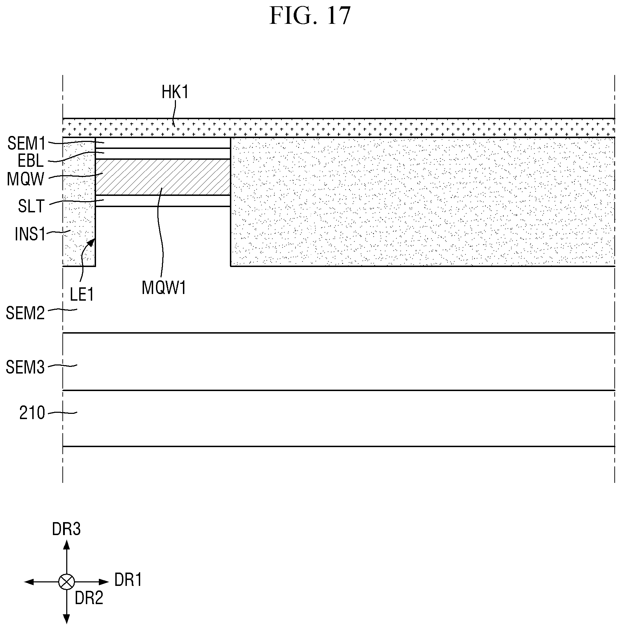

Next, referring to FIGS. 16 and 17, first light-emitting elements LE1 are formed in the plurality of first openings OP1 and a first hard mask HK1 covering the first light-emitting elements LE1 is formed. (S122 in FIG. 13)

The formation process of the first light-emitting elements LE1 may be performed through an epitaxial growth method in the same way as the second semiconductor layer SEM2 and the third semiconductor layer SEM3. When the upper surface of the second semiconductor layer SEM2 is exposed by the plurality of first openings OP1, a semiconductor crystal is grown by injecting the precursor material onto the second semiconductor layer SEM2. The second semiconductor layer SEM2 may be continuously grown using the precursor material.

Subsequently, the first light-emitting element LE1 is formed by sequentially growing the superlattice layer SLT, the first active layer MQW1, the electron-blocking layer EBL, and the first semiconductor layer SEM1. In this process, the first light-emitting elements LE1 having the first active layer MQW1 are formed, and the second active layer MQW2 or the light-emitting elements LE2 and LE3 including the first active layer MQW1 may be formed in subsequent repeated processes.

Next, the first hard mask HK1 covering the first light-emitting element LE1 is formed. The first hard mask HK1 may include the insulating material, such as silicon oxide (SiOx), silicon nitride (SiNx), or silicon oxynitride (SiOxNy), and may include the same material as the above-described insulating layer INS1. However, implementations are not limited thereto. The first hard mask HK1 may be a passivation film or a barrier film protecting the first light-emitting element LE1.

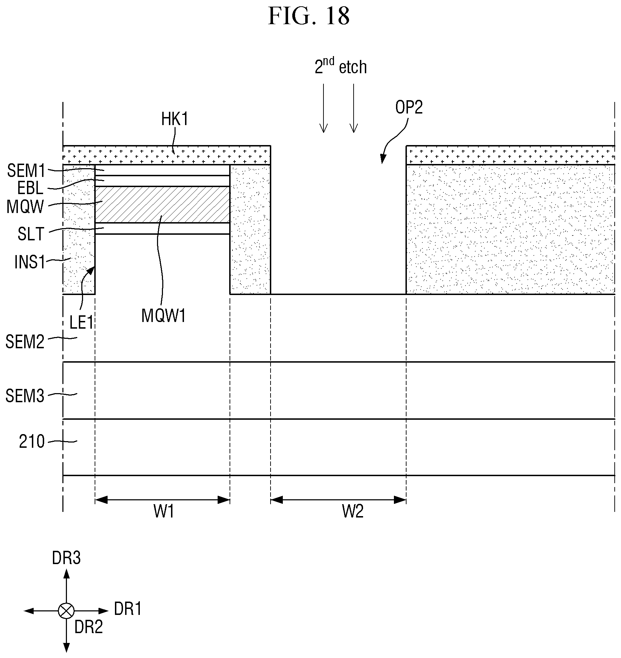

Next, referring to FIG. 18, a plurality of second openings OP2 penetrating the first hard mask HK1 and the insulating layer INS1 are formed. (S123 of FIG. 13)

For example, the plurality of second openings OP2 exposing the second semiconductor layer SEM2 are formed by etching (second etch) the first hard mask HK1 and the insulating layer INS1. The plurality of second openings OP2 may be located adjacent to the plurality of first openings OP1, and the plurality of second openings OP2 may be spaced apart from each other. The width W2 of the plurality of second openings OP2 is the same as the width W1 of the plurality of first openings OP1.

Next, referring to FIG. 19, the second light-emitting elements LE2 are formed in the plurality of second openings OP2 and a second hard mask HK2 covering the second light-emitting elements LE2 is formed. (S124 of FIG. 13)

The second light-emitting elements LE2 grow semiconductor crystals by injecting the precursor material onto the upper surface of the second semiconductor layer SEM2 exposed by the plurality of second openings OP2. The second semiconductor layer SEM2 may be continuously grown using the precursor material. Then, the second light-emitting element LE2 is formed by sequentially growing the superlattice layer SLT, the second active layer MQW2, the electron-blocking layer EBL, and the first semiconductor layer SEM1. The second active layer MQW2 may be formed with a different composition from that of the first active layer MQW1 of the first light-emitting element LE1 described above. For example, the indium content of the second active layer MQW2 may be less than that of the first active layer MQW1.

Next, the second hard mask HK2 covering the second light-emitting element LE2 and the first hard mask HK1 is formed. The second hard mask HK2 may include the insulating material, such as silicon oxide (SiOx), silicon nitride (SiNx), or silicon oxynitride (SiOxNy), and may include the same material as the first hard mask HK1 described above.

Next, referring to FIG. 20, a plurality of third openings OP3 penetrating the first hard mask HK1, the second hard mask HK2, and the insulating layer INS1 are formed. (S125 of FIG. 13)

For example, the plurality of third openings OP3 exposing the second semiconductor layer SEM2 are formed by etching (third etch) the first hard mask HK1, the second hard mask HK2, and the insulating layer INS1. The plurality of third openings OP3 may be located adjacent to the plurality of first openings OP1 and second openings OP2, and the plurality of third openings OP3 may be spaced apart from each other. The width W3 of the plurality of second openings OP3 may be formed to be the same as the width W1 of the plurality of first openings OP1 and the width W2 of the plurality of second openings OP2.

Next, referring to FIG. 21, third light-emitting elements LE3 are formed in the plurality of third openings OP3, and the first hard mask HK1 and the second hard mask HK2 are removed. (FIG. 13 S126)

The third light-emitting elements LE3 grow semiconductor crystals by injecting the precursor material onto the upper surface of the second semiconductor layer SEM2 exposed by the plurality of third openings OP3. The second semiconductor layer SEM2 may be continuously grown using the precursor material. Subsequently, the third light-emitting element LE3 is formed by sequentially growing the superlattice layer SLT, the third active layer MQW2, the electron-blocking layer EBL, and the first semiconductor layer SEM1. The third active layer MQW3 may be formed with a different composition from that of the second active layer MQW2 of the second light-emitting element LE2 described above. For example, the indium content of the third active layer MQW3 may be less than that of the second active layer MQW2.

Next, the first hard mask HK1 and the second hard mask HK2 are removed. As the first hard mask HK1 and the second hard mask HK2 are removed, the surface of the first semiconductor layer SEM1 of each of the light-emitting elements LE1, LE2, and LE3 may be exposed outside the insulating layer INS1. For example, surfaces of the first semiconductor layer SEM1 of each of the light-emitting elements LE1, LE2, and LE3 may be mutually aligned with the surface of the insulating layer INS1.

A process of removing the first hard mask HK1 and the second hard mask HK2 may be performed through the etching process. The etching process may be dry etching, wet etching, reactive ion etching (RIE), deep reactive ion etching (DRIE), inductively coupled plasma reactive ion etching (ICP-RIE) or the like.

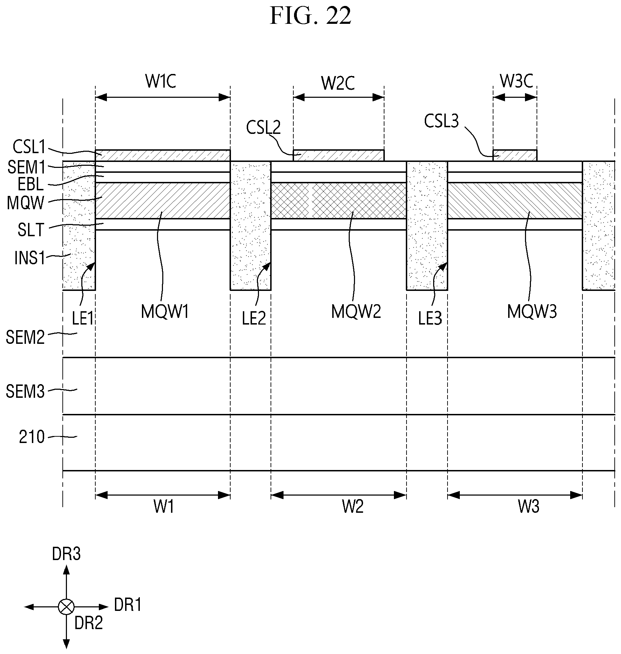

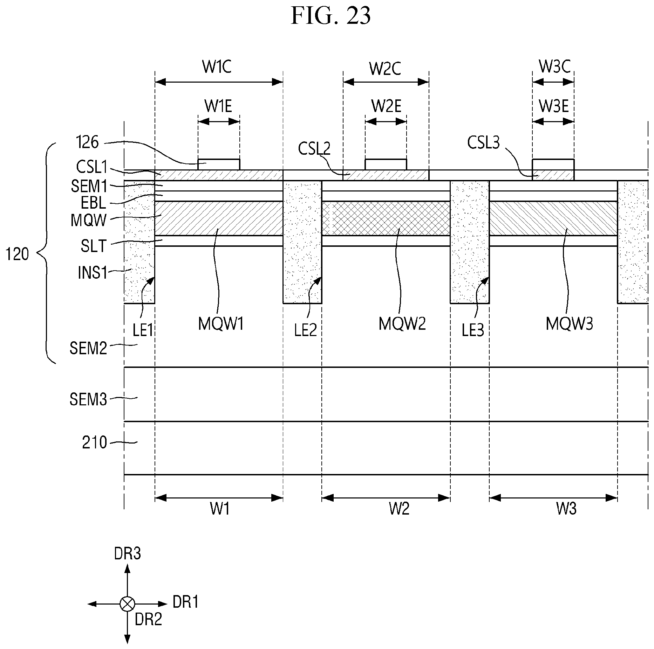

Next, referring to FIGS. 22 and 23, the light-emitting element layer 120 is formed by forming the current-spreading layers CSL and the connection electrode 126 on each of the light-emitting elements LE1, LE2, and LE3. (S130 in FIG. 19)

The current-spreading layers CSL may be directly formed on the first semiconductor layer SEM1 of each of the light-emitting elements LE1, LE2, and LE3 through a photo process. The light-emitting element layer 120 located on the second substrate 210 may be manufactured through the above process.

The current-spreading layers CSL have different sizes for different light-emitting elements LE1, LE2, and LE3 for emitting light of different wavelengths. When the light-emitting elements LE1, LE2, and LE3 have the same size, the size of the current-spreading layer CSL is formed differently according to the indium content of the active layer MQW.

Referring to FIG. 22, the first current-spreading layer CSL1 of the first light-emitting element LE1 is different from the second current-spreading layer CSL2 of the second light-emitting element LE2 and the third current-spreading layer CSL3 of the third light-emitting element LE3. The width W1C of the first current-spreading layer CSL1 is formed wider than the second width W2C of the second current-spreading layer CSL2 and may be formed wider than the third width W3C. The width W1C of the first current-spreading layer CSL1 may be, for example, about 0.1 µm to about 5 µm, but is not limited thereto.

The width W2C may be wider than the third width W3C, or the second width W2C may be substantially the same as the third width W3C.

Referring to FIG. 23, the connection electrode 126 is formed by stacking and etching a connection electrode material layer on the current-spreading layers CSL1, CSL2, and CSL3. The connection electrode material layer may include gold (Au), copper (Cu), aluminum (Al), or tin (Sn).

The width W1E of the connection electrode 126 of the first light-emitting element LE1 may be the same as the width W2E of the connection electrode 126 of the second light-emitting element LE2 and may be the same as the width W3E of the connection electrode 126 of the third light-emitting element LE3.

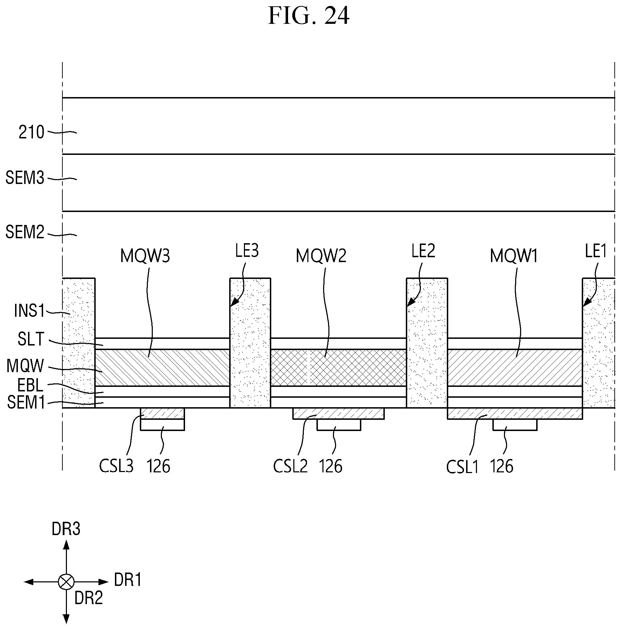

Next, referring to FIGS. 24 to 27, the light-emitting element layer 120 and the semiconductor circuit board 100 are bonded. (S150 in FIG. 12)

First, the semiconductor circuit board 100 is prepared. The semiconductor circuit board 100 may include a plurality of pixel circuit units PXC and the pixel electrodes 111 on the first substrate 110.

For example, the pixel electrodes 111 are formed on the first substrate 110 on which the plurality of pixel circuit units PXC are formed.

Then, the semiconductor circuit board 100 and the light-emitting element layer 120 are bonded after aligning the light-emitting element layer 120 on the semiconductor circuit board 100.

For example, the pixel electrodes 111 of the semiconductor circuit board 100 are brought into contact with the connection electrodes 126 of the light-emitting element layer 120. Then, the semiconductor circuit board 100 and the light-emitting element layer 120 may be bonded together by melting and bonding the connection electrodes 126 to the pixel electrode 111 while applying an amount (e.g., a predetermined amount) of heat.

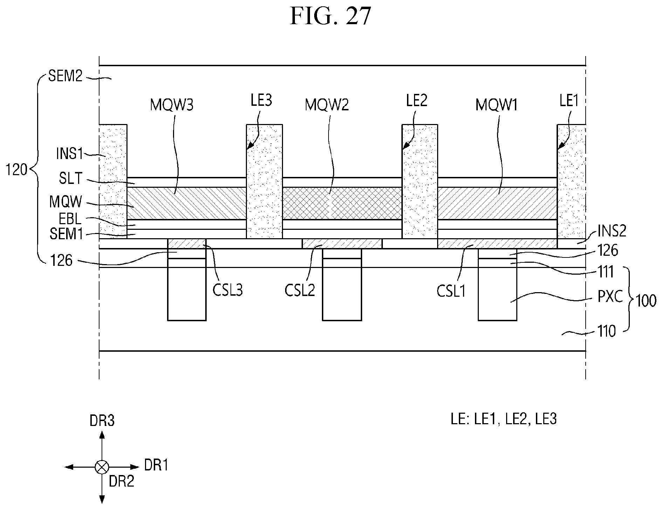

Next, referring to FIG. 27, the display device may be manufactured by removing the second substrate 210 and the third semiconductor layer SEM3 of the light-emitting element layer 120 by etching (e.g., by a fourth etch). At least a portion of the second substrate 210 and the third semiconductor layer SEM3 may be removed by chemical mechanical polishing (CMP) or the above-described etching method. Although the third semiconductor layer SEM3 may be completely etched by this process, it is not limited thereto, and at least a portion of the third semiconductor layer SEM3 may remain on the second semiconductor layer SEM2 without being removed.

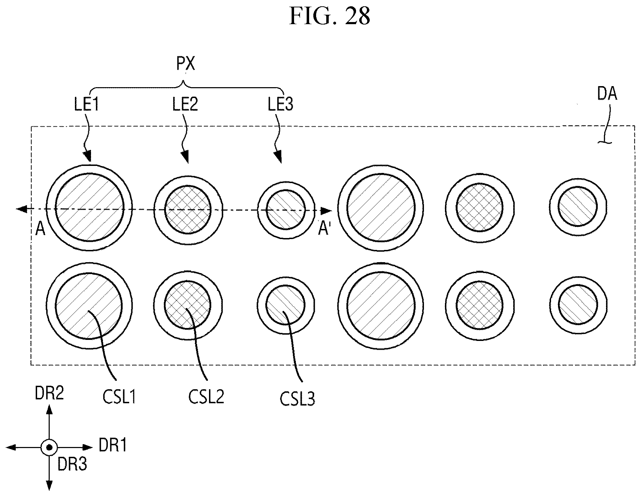

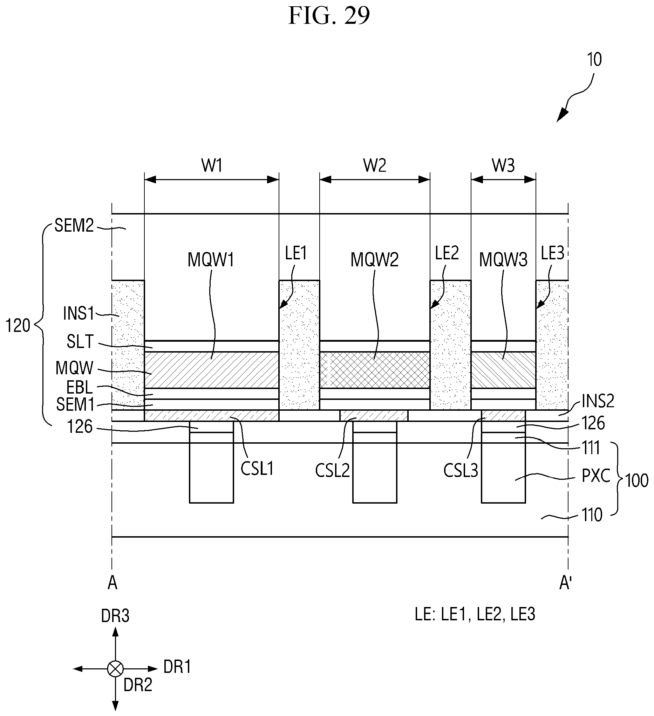

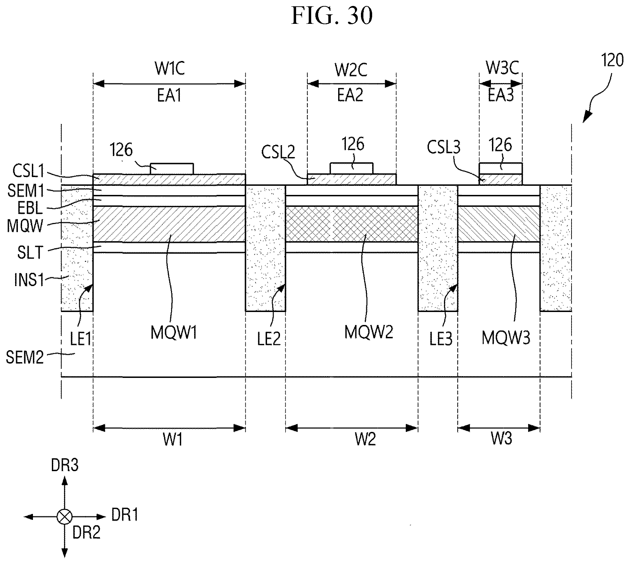

FIG. 28 is a layout diagram illustrating a plurality of pixels. FIG. 29 is a cross-sectional view illustrating an example of a display panel taken along the line A-A' of FIG. 28. FIG. 30 is a cross-sectional view illustrating an example of a light-emitting element structure of a display panel.

The implementations of FIG. 28 to 30 are different from the implementations of FIGS. 4 and 8 in that the widths W1, W2, and W3 of the first light-emitting element LE1, the second light-emitting element LE2, and the third light-emitting element LE3 are different from each other. In FIGS. 28 to 30, overlapping descriptions with the implementations of FIGS. 3, 4, and 8 are omitted.

The light-emitting element layer 120 may include the light-emitting elements LE, the insulating layer INS1, the current-spreading layer CSL, and the connection electrode 126. The width W1 of the first light-emitting element LE1 is the same as the width W2 of the second light-emitting element LE2 and may be wider than the width W3 of the third light-emitting element LE3. The widths W1, W2, and W3 of each of the light-emitting elements LE1, LE2, and LE3 may be the distance between one side and the other side thereof in the first direction DR1. When each of the light-emitting elements LE1, LE2, and LE3 has a circular shape, the width may be the diameter of each light-emitting element LE1, LE2, and LE3.

The width W1 of the first light-emitting element LE1 is the same as the width W2 of the second light-emitting element LE2 and may be greater than the width W3 of the third light-emitting element LE3. When the width W1 of the first light-emitting element LE1 is greater than the width W3 of the third light-emitting element LE3, the width W2 of the second light-emitting element LE2 may be greater than or equal to the width W3 of the third light-emitting element LE3. For example, the width W2 of the second light-emitting element LE2 may be greater than the width W3 of the third light-emitting element LE3. Also, the width W2 of the second light-emitting element LE2 may be the same as the width W3 of the third light-emitting element LE3.

Because the current-spreading layer CSL directly contacts the first semiconductor layer SEM1 and reduces the resistance between the first semiconductor layers SEM1, the light-emitting element LE may emit light only in an area directly contacting the current-spreading layer CSL. Accordingly, a region in direct contact between the current-spreading layer CSL and the first semiconductor layer SEM1 may be defined as an emission region. For example, when the first light-emitting element LE1 includes the first current-spreading layer CSL1 having the first width W1C, the second light-emitting element LE2 includes the second current-spreading layer CSL2 having the second width W2C, and the third light-emitting element LE3 includes the third current-spreading layer CSL3 having the third width W3C, the first light-emitting element LE1 has the first light-emitting area EA1 equal to the first width W1C, the second light-emitting element LE2 has the second light-emitting area EA2 equal to the second width W2C, and the third light-emitting element LE3 has the third light-emitting area EA3 equal to the third width W3C.

The fact that the first width W1C is greater than the second width W2C and the third width W3C implies that the area of the first light-emitting area EA1 is greater than the area of the second light-emitting area EA2 and the area of the third light-emitting area EA3. The area of the first light-emitting area EA1 may be the same as that of the first current-spreading layer CSL1, the area of the second light-emitting area EA2 may be the same as that of the second current-spreading layer CSL2, and the area of the third light-emitting area EA3 may be the same as that of the third current-spreading layer CSL3.

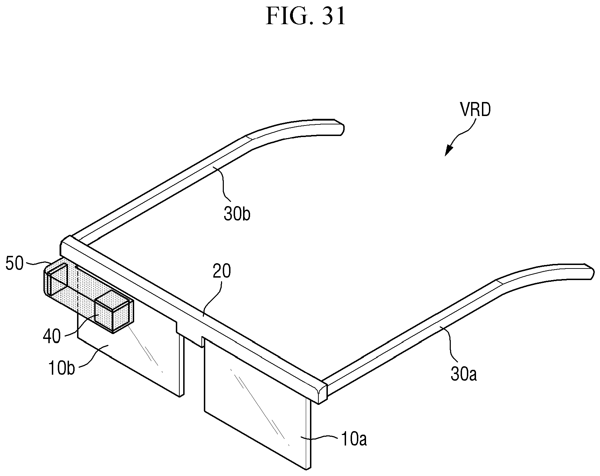

FIG. 31 illustrates a virtual reality device 1 in which the display device 10 is included is used.

Referring to FIG. 31, the virtual reality device 1 may be a device in a form of glasses. The virtual reality device 1 may include a display device 10, a left-eye lens 10a, a right-eye lens 10b, a support frame 20, left and right legs 30a and 30b, a reflective member 40, and a display device housing 50.

FIG. 31 illustrates the virtual reality device 1 including the two legs 30a and 30b. However, the disclosure is not limited thereto. The virtual reality device 1 may be used in a head-mounted display including a head-mounted band that may be mounted on a user's head, instead of including the legs 30a and 30b. For example, the virtual reality device 1 may not be limited to the example shown in FIG. 31, and may be applied in various forms and in various electronic devices.

The display device housing 50 may receive the display device 10 and the reflective member 40. An image displayed on the display device 10 may be reflected from the reflective member 40 and provided to a user's right eye through the right-eye lens 10b. Thus, the user may view a virtual reality image displayed on the display device 10 via the right eye.

FIG. 31 illustrates that the display device housing 50 is located at a right end of the support frame 20. However, the disclosure is not limited thereto. For example, the display device housing 50 may be located at a left end of the support frame 20. In this case, the image displayed on the display device 10 may be reflected from the reflective member 40 and provided to the user's left eye via the left-eye lens 10a. Thus, the user may view the virtual reality image displayed on the display device 10 via the left eye. As another example, the display device housing 50 may be located at each of the left end and the right end of the support frame 20. In this case, the user may view the virtual reality image displayed on the display device 10 via both the left eye and the right eye.

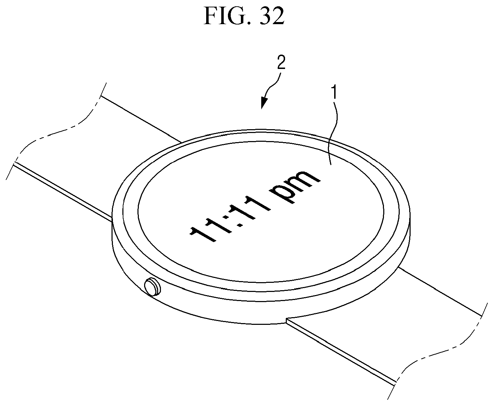

FIG. 32 illustrates a smart device including a display device.

Referring to FIG. 32, a display device 10 may be applied to a smart watch 2 as one of smart devices.

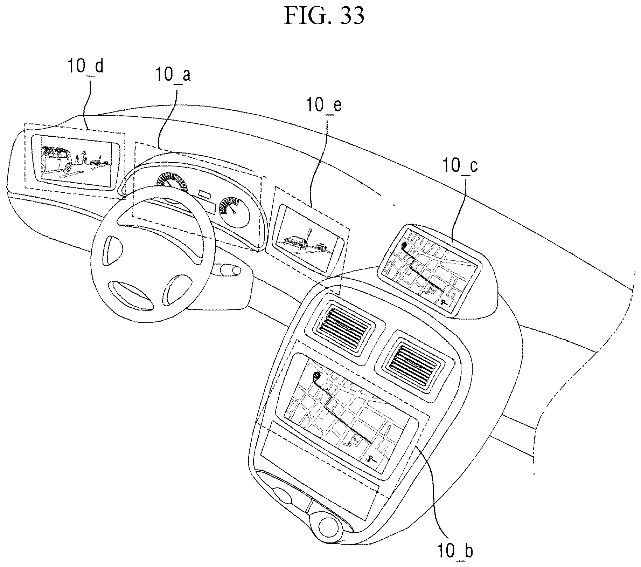

FIG. 33 illustrates a vehicle in which display devices are used.

Referring to FIG. 33, the display devices 10_a, 10_b, or 10_c may be respectively applied to the dashboard of the vehicle, applied to the center fascia of the vehicle, or applied to a CID (Center Information Display) located on the dashboard of the vehicle. Further, each of the display devices 10_d and 10_e may be applied to each mirror display that replaces each of side-view mirrors of the vehicle.

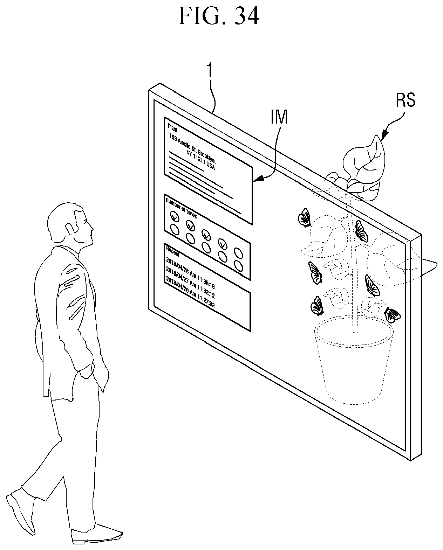

FIG. 34 is an example diagram illustrating a transparent display device including a display device.

Referring to FIG. 34, a display device may be applied to a transparent display device. The transparent display device may transmit light therethrough while displaying an image IM thereon. Therefore, a user located in front of the transparent display device may not only view the image IM displayed on the display device 10, but also may view an object RS or a background located in rear of the transparent display device. In case that the display device 10 is applied to the transparent display device, the first substrate 110 of the display device 10 shown in FIG. 7 may include a light transmitting portion that may transmit light therethrough or may be made of a material that may transmit light therethrough.

In concluding the detailed description, those skilled in the art will appreciate that many variations and modifications can be made to the embodiments without departing from the scope of the invention as set out in the claims. Therefore, the disclosed embodiments are used in a generic and descriptive sense only and not for purposes of limitation.

## Claims

1. A light-emitting element structure comprising:
light-emitting elements (LE) comprising a first light-emitting element (LE1) for emitting light of a first wavelength and a second light-emitting element (LE2) for emitting light of a second wavelength, and comprising current-spreading layers (CSL) comprising a first current-spreading layer (CSL1) having a first width (W1C) on the first light-emitting element (LE1) and a second current-spreading layer (CSL2) having a second width (W2C) that is less than the first width (W1C) on the second light-emitting element (LE2); and
an insulating layer (INS1) between the light-emitting elements (LE),
**characterized in that** the first light-emitting element (LE1) and the second light-emitting element (LE2) have the same width (W1, W2).

2. The light-emitting element structure of claim 1, wherein the first wavelength corresponds to red light, and wherein the second wavelength corresponds to green light or blue light.

3. The light-emitting element structure of any one of the preceding claims, wherein the light-emitting elements (LE) further comprise a third light-emitting element (LE3) for emitting light of a third wavelength,
wherein the current-spreading layers (CSL) further comprise a third current-spreading layer (CSL3) on the third light-emitting element (LE3),
wherein the first wavelength corresponds to red light,
wherein the second wavelength corresponds to green light, and
wherein the third wavelength corresponds to blue light.

4. The light-emitting element structure of claim 3, further comprising a first light-emitting area (EA1) corresponding to the first current-spreading layer (CSL1), a second light-emitting area (EA2) corresponding to the second current-spreading layer (CSL2), and a third light-emitting area (EA3) corresponding to the third current-spreading layer (CSL3),
wherein a first emission region of the first light-emitting area (EA1) is larger than a second emission region of the second light-emitting area (EA2) and a third emission region of the third light-emitting area (EA3).

5. The light-emitting element structure of claim 4, wherein the second emission region is larger than or equal in size to the third emission region.

6. The light-emitting element structure of claim 3, 4 or 5, wherein the planar shape of the first current-spreading layer (CSL1), the second current-spreading layer (CSL2), and the third current-spreading layer (CSL3) is circular or polygonal.

7. The light-emitting element structure of any one of claims 3 to 6, wherein the light-emitting elements (LE) comprise a first semiconductor layer (SEM1), a second semiconductor layer (SEM2), and an active layer (MQW) between the first semiconductor layer (SEM1) and the second semiconductor layer (SEM2),
wherein the first light-emitting element (LE1) comprises a first active layer (MQW1),
wherein the second light-emitting element (LE2) comprises a second active layer (MQW2),
wherein the third light-emitting element (LE3) comprises a third active layer (MQW3),
wherein the first active layer, the second active layer, and the third active layer contain indium,
wherein an indium content of the first active layer is greater than an indium content of the second active layer and an indium content of the third active layer, and
wherein the indium content of the second active layer is greater than the indium content of the third active layer.

8. The light-emitting element structure of any one of the preceding claims, further comprising connection electrodes (126) on the current-spreading layers (CSL), and
wherein the connection electrodes respectively have the same width (W1C, W2C, W3C) as the current-spreading layers (CSL).

9. The light-emitting element structure of any one of claims 1 to 7, further comprising connection electrodes (126) on the current-spreading layers (CSL), and respectively having widths that are different from the widths (W1C, W2C, W3C) of the current-spreading layers (CSL).

10. A display device comprising:
pixel electrodes (111) on a substrate (110);
a light-emitting element structure according to any one of the preceding claims on the pixel electrodes (111).

11. The display device of claim 10 when dependent on claim 8 or 9, wherein the connection electrodes (126) are between the current-spreading layers (CSL) and the pixel electrodes (111).

## Patentansprüche

1. Lichtemittierende Elementstruktur, umfassend:
lichtemittierende Elemente (LE), umfassend ein erstes lichtemittierendes Element (LE1) zum Emittieren von Licht einer ersten Wellenlänge und ein zweites lichtemittierendes Element (LE2) zum Emittieren von Licht einer zweiten Wellenlänge, und umfassend stromverteilende Schichten (CSL), umfassend eine erste stromverteilende Schicht (CSL1), die eine erste Breite (W1C) auf dem ersten lichtemittierenden Element (LE1) aufweist, und eine zweite stromverteilende Schicht (CSL2), die eine zweite Breite (W2C), die kleiner ist als die erste Breite (W1C), auf dem zweiten lichtemittierenden Element (LE2) aufweist; und
eine Isolierschicht (INS1) zwischen den lichtemittierenden Elementen (LE),
**dadurch gekennzeichnet, dass** das erste lichtemittierende Element (LE1) und das zweite lichtemittierende Element (LE2) die gleiche Breite (W1, W2) aufweisen.

2. Lichtemittierende Elementstruktur nach Anspruch 1, wobei die erste Wellenlänge rotem Licht entspricht und wobei die zweite Wellenlänge grünem Licht oder blauem Licht entspricht.

3. Lichtemittierende Elementstruktur nach einem der vorhergehenden Ansprüche, wobei die lichtemittierenden Elemente (LE) ferner ein drittes lichtemittierendes Element (LE3) zum Emittieren von Licht einer dritten Wellenlänge umfassen,
wobei die stromverteilenden Schichten (CSL) ferner eine dritte stromverteilende Schicht (CSL3) auf dem dritten lichtemittierenden Element (LE3) umfassen,
wobei die erste Wellenlänge rotem Licht entspricht,
wobei die zweite Wellenlänge grünem Licht entspricht, und
wobei die dritte Wellenlänge blauem Licht entspricht.

4. Lichtemittierende Elementstruktur nach Anspruch 3, ferner umfassend einen ersten lichtemittierenden Bereich (EA1), der der ersten stromverteilenden Schicht (CSL1) entspricht, einen zweiten lichtemittierenden Bereich (EA2), der der zweiten stromverteilenden Schicht (CSL2) entspricht, und einen dritten lichtemittierenden Bereich (EA3), der der dritten stromverteilenden Schicht (CSL3) entspricht,
wobei eine erste Emissionsregion des ersten lichtemittierenden Bereichs (EA1) größer ist als eine zweite Emissionsregion des zweiten lichtemittierenden Bereichs (EA2) und eine dritte Emissionsregion des dritten lichtemittierenden Bereichs (EA3).

5. Lichtemittierende Elementstruktur nach Anspruch 4, wobei die zweite Emissionsregion größer als oder gleich groß wie die dritte Emissionsregion ist.

6. Lichtemittierende Elementstruktur nach Anspruch 3, 4 oder 5, wobei die planare Form der ersten stromverteilenden Schicht (CSL1), der zweiten stromverteilenden Schicht (CSL2) und der dritten stromverteilenden Schicht (CSL3) kreisförmig oder polygonal ist.

7. Lichtemittierende Elementstruktur nach einem der Ansprüche 3 bis 6, wobei die lichtemittierenden Elemente (LE) eine erste Halbleiterschicht (SEM1), eine zweite Halbleiterschicht (SEM2) und eine aktive Schicht (MQW) zwischen der ersten Halbleiterschicht (SEM1) und der zweiten Halbleiterschicht (SEM2) umfassen,
wobei das erste lichtemittierende Element (LE1) eine erste aktive Schicht (MQW1) umfasst,
wobei das zweite lichtemittierende Element (LE2) eine zweite aktive Schicht (MQW2) umfasst,
wobei das dritte lichtemittierende Element (LE3) eine dritte aktive Schicht (MQW3) umfasst,
wobei die erste aktive Schicht, die zweite aktive Schicht und die dritte aktive Schicht Indium enthalten,
wobei ein Indiumgehalt der ersten aktiven Schicht größer ist als ein Indiumgehalt der zweiten aktiven Schicht und ein Indiumgehalt der dritten aktiven Schicht, und
wobei der Indiumgehalt der zweiten aktiven Schicht größer ist als der Indiumgehalt der dritten aktiven Schicht.

8. Lichtemittierende Elementstruktur nach einem der vorhergehenden Ansprüche, ferner umfassend Verbindungselektroden (126) auf den stromverteilenden Schichten (CSL), und
wobei die Verbindungselektroden jeweils die gleiche Breite (W1C, W2C, W3C) wie die stromverteilenden Schichten (CSL) aufweisen.

9. Lichtemittierende Elementstruktur nach einem der Ansprüche 1 bis 7, ferner umfassend Verbindungselektroden (126) auf den stromverteilenden Schichten (CSL), und die jeweils Breiten aufweisen, die sich von den Breiten (W1C, W2C, W3C) der stromverteilenden Schichten (CSL) unterscheiden.

10. Anzeigevorrichtung, umfassend:
Pixelelektroden (111) auf einem Substrat (110);
eine lichtemittierende Elementstruktur nach einem der vorhergehenden Ansprüche auf den Pixelelektroden (111).

11. Anzeigevorrichtung nach Anspruch 10, wenn abhängig von Anspruch 8 oder 9, wobei die Verbindungselektroden (126) zwischen den stromverteilenden Schichten (CSL) und den Pixelelektroden (111) sind.

## Revendications

1. Structure d'éléments électroluminescents comprenant :
des éléments électroluminescents (LE) comprenant un premier élément électroluminescent (LE1) destiné à émettre de la lumière d'une première longueur d'onde et un deuxième élément électroluminescent (LE2) destiné à émettre de la lumière d'une deuxième longueur d'onde, et comprenant des couches de diffusion de courant (CSL) comprenant une première couche de diffusion de courant (CSL1) présentant une première largeur (W1C) sur le premier élément électroluminescent (LE1) et une deuxième couche de diffusion de courant (CSL2) présentant une deuxième largeur (W2C) qui est moins grande que la première largeur (W1C) sur le deuxième élément électroluminescent (LE2) ; et
une couche isolante (INS1) entre les éléments électroluminescents (LE),
**caractérisée en ce que** le premier élément électroluminescent (LE1) et le deuxième élément électroluminescent (LE2) présentent la même largeur (W1, W2).

2. Structure d'éléments électroluminescents selon la revendication 1, ladite première longueur d'onde correspondant à de la lumière rouge, et ladite deuxième longueur d'onde correspondant à de la lumière verte ou de la lumière bleue.

3. Structure d'éléments électroluminescents selon l'une quelconque des revendications précédentes, lesdits éléments électroluminescents (LE) comprenant en outre un troisième élément électroluminescent (LE3) destiné à émettre de la lumière d'une troisième longueur d'onde,
lesdites couches de diffusion de courant (CSL) comprenant en outre une troisième couche de diffusion de courant (CSL3) sur le troisième élément électroluminescent (LE3),
ladite première longueur d'onde correspondant à de la lumière rouge,
ladite deuxième longueur d'onde correspondant à de la lumière verte, et
ladite troisième longueur d'onde correspondant à la lumière bleue.

4. Structure d'éléments électroluminescents selon la revendication 3, comprenant en outre une première zone électroluminescente (EA1) correspondant à la première couche de diffusion de courant (CSL1), une deuxième zone électroluminescente (EA2) correspondant à la deuxième couche de diffusion de courant (CSL2), et une troisième zone électroluminescente (EA3) correspondant à la troisième couche de diffusion de courant (CSL3),
la première région d'émission de la première zone électroluminescente (EA1) étant plus grande qu'une deuxième région d'émission de la deuxième zone électroluminescente (EA2) et qu'une troisième région d'émission de la troisième zone électroluminescente (EA3).

5. Structure d'éléments électroluminescents selon la revendication 4, ladite deuxième région d'émission étant d'une taille supérieure ou égale à la troisième région d'émission.

6. Structure d'éléments électroluminescents selon la revendication 3, 4 ou 5, ladite forme plane de la première couche de diffusion de courant (CSL1), de la deuxième couche de diffusion de courant (CSL2) et de la troisième couche de diffusion de courant (CSL3) étant circulaire ou polygonale.

7. Structure d'éléments électroluminescents selon l'une quelconque des revendications 3 à 6, lesdits éléments électroluminescents (LE) comprenant une première couche semi-conductrice (SEM1), une seconde couche semi-conductrice (SEM2) et une couche active (MQW) entre la première couche semi-conductrice (SEM1) et la seconde couche semi-conductrice (SEM2),
ledit premier élément électroluminescent (LE1) comprenant une première couche active (MQW1),
ledit deuxième élément électroluminescent (LE2) comprenant une deuxième couche active (MQW2),
ledit troisième élément électroluminescent (LE3) comprenant une troisième couche active (MQW3),
ladite première couche active, ladite deuxième couche active et ladite troisième couche active contenant de l'indium,
une teneur en indium de la première couche active étant supérieure à une teneur en indium de la deuxième couche active et à une teneur en indium de la troisième couche active, et
ladite teneur en indium de la deuxième couche active étant supérieure à la teneur en indium de la troisième couche active.

8. Structure d'éléments électroluminescents selon l'une quelconque des revendications précédentes, comprenant en outre des électrodes de connexion (126) sur les couches de diffusion de courant (CSL), et
lesdites électrodes de connexion présentant respectivement la même largeur (W1C, W2C, W3C) que les couches de diffusion de courant (CSL).

9. Structure d'éléments électroluminescents selon l'une quelconque des revendications 1 à 7, comprenant en outre des électrodes de connexion (126) sur les couches de diffusion de courant (CSL), et présentant respectivement des largeurs qui sont différentes des largeurs (W1C, W2C, W3C) des couches de diffusion de courant (CSL).

10. Dispositif d'affichage comprenant :
des électrodes de pixel (111) sur un substrat (110) ;
une structure d'éléments électroluminescents selon l'une quelconque des revendications précédentes sur les électrodes de pixel (111).

11. Dispositif d'affichage selon la revendication 10 lorsqu'elle dépend de la revendication 8 ou 9, lesdites électrodes de connexion (126) se trouvant entre les couches de diffusion de courant (CSL) et les électrodes de pixel (111).
